# EUROPEAN PATENT APPLICATION

(11) **EP 4 811 670 A1**
(43) Date of publication of application: **23.09.2026**
(21) Application number: 24920596.4
(22) Date of filing: 19.12.2024
(51) Int. Cl.: H04B 1/401, H04B 1/50, H04B 7/06, H01Q 21/28, H03K 17/687, H03K 17/693, H04B 7/08, H01Q 5/307

(54) **ELECTRONIC DEVICE INCLUDING ANTENNA**

(30) Priority: 25.01.2024 KR 20240011914; 21.03.2024 KR 20240039414
(71) Applicant: Samsung Electronics Co., Ltd., Suwon-si, Gyeonggi-do 16677 (KR)
(72) Inventor: CHO, Namjun, Suwon-si, Gyeonggi-do 16677 (KR); NA, Hyoseok, Suwon-si, Gyeonggi-do 16677 (KR)
(74) Representative: Gulde & Partner
(86) International application number: PCT/KR2024/020738
(87) International publication number: WO 2025/159347

(57) **Abstract**

In embodiments, an electronic device is provided. The electronic device may comprise: a plurality of antennas including a first antenna and a second antenna; a radio frequency (RF) transceiver; a first radio frequency front end (RFFE) module connected to the RF transceiver and configured to transmit or receive a signal; a second RFFE module connected to the RF transceiver and configured to receive a signal; a first switching circuit connected to the first RFFE module; and a second switching circuit connected to the second RFFE module. The first switching circuit may be configured to electrically connect the first RFFE module selectively to the first antenna in a first connection mode or to the second antenna through the second switching circuit in a second connection mode. The second switching circuit may be configured to electrically connect the second RFFE module selectively to the second antenna in the first connection mode or to the first antenna through the first switching circuit in the second connection mode.

## Description

### [Technical Field]

The following descriptions relate to an electronic device including an antenna.

### [Background Art]

An electronic device may include a radio frequency front end (RFFE) module to transmit or receive a signal. The electronic device may transmit a signal through an antenna connected to the RFFE module.

The above-described information may be provided as a related art for the purpose of helping understanding of the present disclosure. No argument or decision is made as to whether any of the above description may be applied as a prior art related to the present disclosure.

### [DISCLOSURE]

### [Technical Solution]

In embodiments, an electronic device is provided. The electronic device may comprise a plurality of antennas including a first antenna and a second antenna, a radio frequency (RF) transceiver, a first radio frequency front end (RFFE) module connected to the RF transceiver and configured to transmit or receive signals, a second RFFE module connected to the RF transceiver and configured to receive signals, a first switching circuit connected to the first RFFE module, and a second switching circuit connected to the second RFFE module. The first switching circuit may be configured to electrically connect the first RFFE module to the first antenna in a first connection mode or the second antenna through the second switching circuit in a second connection mode selectively. The second switching circuit may be configured to electrically connect the second RFFE module to the second antenna in the first connection mode or the first antenna through the first switching circuit in the second connection mode selectively. In the first switching circuit, insertion loss of a first sub-path switch configured to connect the first RFFE module and the second switching circuit electrically in the second connection mode may be lower than insertion loss of a first main path switch configured to connect the first RFFE module and the first antenna electrically in the first connection mode. In the second switching circuit, insertion loss of a second sub-path switch configured to connect the second RFFE module and the first switching circuit in the second connection mode may be lower than insertion loss of a second main path switch configured to connect the second RFFE module and the second antenna in the first connection mode.

In embodiments, a radio frequency (RF) switch is provided. The radio frequency (RF) switch may comprise a first port, a second port, a third port, a fourth port, a first path switch for connecting the first port and the third port electrically, a second path switch for connecting the first port and the fourth port electrically, a third path switch for connecting the second port and the third port electrically, and a fourth path switch for connecting the second port and the fourth port electrically. Insertion loss of the second path switch may be lower than insertion loss of the first path switch. A value of twice the insertion loss of the second path switch may be, in a decibel basis, within a threshold range in respect of the insertion loss of the first path switch.

### [DESCRIPTION OF THE DRAWINGS]

FIG. 1 is a block diagram of an electronic device in a network environment.
FIG. 2 indicates an example of an electronic device for antenna switching diversity (AS-DIV).
FIGS. 3A and 3B indicate examples of an electronic device for antenna switching diversity using conductive portions of a metal frame.
FIGS. 4A, 4B, and 4C indicate examples of a switching circuit for antenna switching diversity.
FIG. 5 indicates an example of a path switch of a switching circuit.
FIG. 6 indicates an example of a turned-on path switch.
FIGS. 7A and 7B indicate an example of a turned-off path switch.
FIG. 8 indicates an example of transistors of two switching circuits on a signal path.
FIG. 9 is a diagram for describing an RF stress direction.
FIGS. 10A and 10B indicate an example of transistors of two switching circuits on a signal path according to an RF stress direction.

### [MODE FOR INVENTION]

Terms used in the present disclosure are used only to describe a specific embodiment, and may not be intended to limit a range of another embodiment. A singular expression may include a plural expression unless the context clearly means otherwise. Terms used herein, including a technical or a scientific term, may have the same meaning as those generally understood by a person with ordinary skill in the art described in the present disclosure. Among the terms used in the present disclosure, terms defined in a general dictionary may be interpreted as identical or similar meaning to the contextual meaning of the relevant technology and are not interpreted as ideal or excessively formal meaning unless explicitly defined in the present disclosure. In some cases, even terms defined in the present disclosure may not be interpreted to exclude embodiments of the present disclosure.

In various embodiments of the present disclosure described below, a hardware approach will be described as an example. However, since the various embodiments of the present disclosure include technology that uses both hardware and software, the various embodiments of the present disclosure do not exclude a software-based approach.

A term referring to a signal (e.g., a signal, information, a message, or signaling), a term referring to a data type (e.g., a list, a set, or a subset), a term for an calculation state (e.g., a step, an operation, or a procedure), a term referring to data (e.g., a packet, a user stream, information, a bit, a symbol, or codeword), a term referring to a resource (e.g., a symbol, a slot, a subframe, a radio frame, a subcarrier, a resource element (RE), a resource block (RB), a bandwidth part (BWP), or an occasion), a term referring to a channel, a term for a network entity, or a term for a component of a device used in the following description and the like are exemplified for convenience of description. Therefore, the present disclosure is not limited to terms to be described below, and another term having an equivalent technical meaning may be used.

A term referring to a component of an electronic device (e.g., a communication module, a wireless communication module, a substrate, a printed circuit board (PCB), a flexible PCB (FPCB), a module, an antenna, an antenna element, a circuit, a processor, a chip, a component, or a device), a term referring to an RF-related component (a front end module (FEM), a power amplifier module (PAM), a FEM including duplexer (FEMid), a power amplifier module including duplexer (PAMid), a Low noise amplifier PAM including duplexer (LPAMid), a radio frequency front end (RFFE), or a radio frequency integrated circuit (RFIC)), a term referring to a shape of a part (e.g., a structure unit, a structure material, a support part, a contact part, or a protrusion part), a term referring to a connection part between structure units (e.g., a connection part, a contact part, a support part, a contact structure, a conductive member, or assembly), or a term referring to a circuit (e.g., a PCB, an FPCB, a signal line, a feeding line, a data line, an RF signal line, an antenna line, an RF path, an RF module, an RF circuit, a splitter, a divider, a coupler, or a combiner) used in the following description and the like are exemplified for convenience of description. Therefore, the present disclosure is not limited to terms to be described below, and another term having an equivalent technical meaning may be used. In addition, a term such as '...part', '...device', '...material', and '...unit, and the like used below may mean at least one shape structure or may mean a unit processing a function.

In addition, in the present disclosure, the term 'greater than' or 'less than' may be used to determine whether a particular condition is satisfied or fulfilled, but this is only a description to express an example and does not exclude description of 'greater than or equal to' or 'less than or equal to'. A condition described as 'greater than or equal to ' may be replaced with 'greater than', a condition described as 'less than or equal to' may be replaced with 'less than', and a condition described as ' greater than or equal to and less than' may be replaced with 'greater than and less than or equal to'. In addition, hereinafter, 'A' to 'B' refers to at least one of elements from A (including A) to B (including B). Hereinafter, 'C' and/or 'D' means including at least one of 'C' or 'D', that is, {'C', 'D', and 'C' and 'D'}.

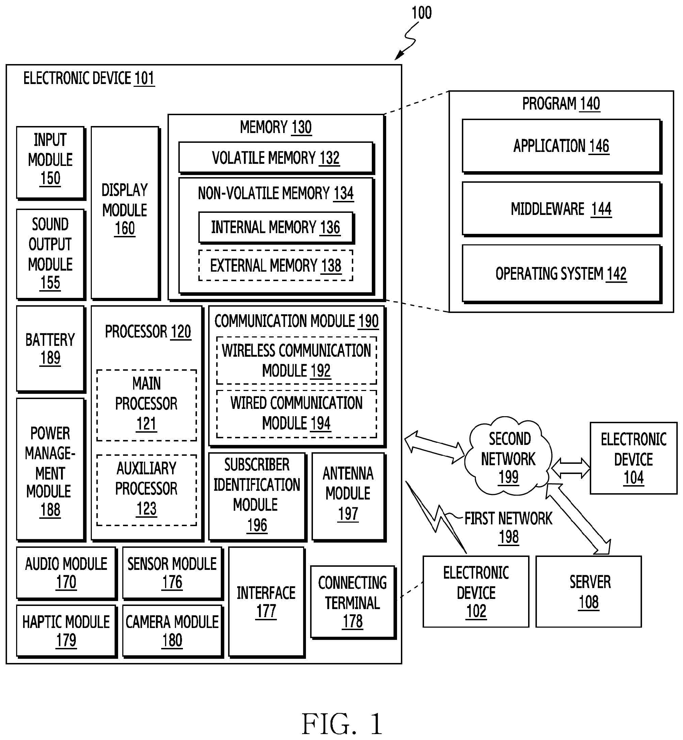

FIG. 1 is a block diagram illustrating an electronic device 101 in a network environment 100 according to various embodiments.

Referring to FIG. 1, the electronic device 101 in the network environment 100 may communicate with an electronic device 102 via a first network 198 (e.g., a short-range wireless communication network), or at least one of an electronic device 104 or a server 108 via a second network 199 (e.g., a long-range wireless communication network). According to an embodiment, the electronic device 101 may communicate with the electronic device 104 via the server 108. According to an embodiment, the electronic device 101 may include a processor 120, memory 130, an input module 150, a sound output module 155, a display module 160, an audio module 170, a sensor module 176, an interface 177, a connecting terminal 178, a haptic module 179, a camera module 180, a power management module 188, a battery 189, a communication module 190, a subscriber identification module(SIM) 196, or an antenna module 197. In some embodiments, at least one of the components (e.g., the connecting terminal 178) may be omitted from the electronic device 101, or one or more other components may be added in the electronic device 101. In some embodiments, some of the components (e.g., the sensor module 176, the camera module 180, or the antenna module 197) may be implemented as a single component (e.g., the display module 160).

The processor 120 may execute, for example, software (e.g., a program 140) to control at least one other component (e.g., a hardware or software component) of the electronic device 101 coupled with the processor 120, and may perform various data processing or computation. According to an embodiment, as at least part of the data processing or computation, the processor 120 may store a command or data received from another component (e.g., the sensor module 176 or the communication module 190) in volatile memory 132, process the command or the data stored in the volatile memory 132, and store resulting data in non-volatile memory 134. According to an embodiment, the processor 120 may include a main processor 121 (e.g., a central processing unit (CPU) or an application processor (AP)), or an auxiliary processor 123 (e.g., a graphics processing unit (GPU), a neural processing unit (NPU), an image signal processor (ISP), a sensor hub processor, or a communication processor (CP)) that is operable independently from, or in conjunction with, the main processor 121. For example, when the electronic device 101 includes the main processor 121 and the auxiliary processor 123, the auxiliary processor 123 may be adapted to consume less power than the main processor 121, or to be specific to a specified function. The auxiliary processor 123 may be implemented as separate from, or as part of the main processor 121.

The auxiliary processor 123 may control at least some of functions or states related to at least one component (e.g., the display module 160, the sensor module 176, or the communication module 190) among the components of the electronic device 101, instead of the main processor 121 while the main processor 121 is in an inactive (e.g., sleep) state, or together with the main processor 121 while the main processor 121 is in an active state (e.g., executing an application). According to an embodiment, the auxiliary processor 123 (e.g., an image signal processor or a communication processor) may be implemented as part of another component (e.g., the camera module 180 or the communication module 190) functionally related to the auxiliary processor 123. According to an embodiment, the auxiliary processor 123 (e.g., the neural processing unit) may include a hardware structure specified for artificial intelligence model processing. An artificial intelligence model may be generated by machine learning. Such learning may be performed, e.g., by the electronic device 101 where the artificial intelligence is performed or via a separate server (e.g., the server 108). Learning algorithms may include, but are not limited to, e.g., supervised learning, unsupervised learning, semi-supervised learning, or reinforcement learning. The artificial intelligence model may include a plurality of artificial neural network layers. The artificial neural network may be a deep neural network (DNN), a convolutional neural network (CNN), a recurrent neural network (RNN), a restricted boltzmann machine (RBM), a deep belief network (DBN), a bidirectional recurrent deep neural network (BRDNN), deep Q-network or a combination of two or more thereof but is not limited thereto. The artificial intelligence model may, additionally or alternatively, include a software structure other than the hardware structure.

The memory 130 may store various data used by at least one component (e.g., the processor 120 or the sensor module 176) of the electronic device 101. The various data may include, for example, software (e.g., the program 140) and input data or output data for a command related thereto. The memory 130 may include the volatile memory 132 or the non-volatile memory 134.

The program 140 may be stored in the memory 130 as software, and may include, for example, an operating system (OS) 142, middleware 144, or an application 146.

The input module 150 may receive a command or data to be used by another component (e.g., the processor 120) of the electronic device 101, from the outside (e.g., a user) of the electronic device 101. The input module 150 may include, for example, a microphone, a mouse, a keyboard, a key (e.g., a button), or a digital pen (e.g., a stylus pen).

The sound output module 155 may output sound signals to the outside of the electronic device 101. The sound output module 155 may include, for example, a speaker or a receiver. The speaker may be used for general purposes, such as playing multimedia or playing record. The receiver may be used for receiving incoming calls. According to an embodiment, the receiver may be implemented as separate from, or as part of the speaker.

The display module 160 may visually provide information to the outside (e.g., a user) of the electronic device 101. The display module 160 may include, for example, a display, a hologram device, or a projector and control circuitry to control a corresponding one of the display, hologram device, and projector. According to an embodiment, the display module 160 may include a touch sensor adapted to detect a touch, or a pressure sensor adapted to measure the intensity of force incurred by the touch.

The audio module 170 may convert a sound into an electrical signal and vice versa. According to an embodiment, the audio module 170 may obtain the sound via the input module 150, or output the sound via the sound output module 155 or a headphone of an external electronic device (e.g., an electronic device 102) directly (e.g., wiredly) or wirelessly coupled with the electronic device 101.

The sensor module 176 may detect an operational state (e.g., power or temperature) of the electronic device 101 or an environmental state (e.g., a state of a user) external to the electronic device 101, and then generate an electrical signal or data value corresponding to the detected state. According to an embodiment, the sensor module 176 may include, for example, a gesture sensor, a gyro sensor, an atmospheric pressure sensor, a magnetic sensor, an acceleration sensor, a grip sensor, a proximity sensor, a color sensor, an infrared (IR) sensor, a biometric sensor, a temperature sensor, a humidity sensor, or an illuminance sensor.

The interface 177 may support one or more specified protocols to be used for the electronic device 101 to be coupled with the external electronic device (e.g., the electronic device 102) directly (e.g., wiredly) or wirelessly. According to an embodiment, the interface 177 may include, for example, a high definition multimedia interface (HDMI), a universal serial bus (USB) interface, a secure digital (SD) card interface, or an audio interface.

A connecting terminal 178 may include a connector via which the electronic device 101 may be physically connected with the external electronic device (e.g., the electronic device 102). According to an embodiment, the connecting terminal 178 may include, for example, an HDMI connector, a USB connector, a SD card connector, or an audio connector (e.g., a headphone connector).

The haptic module 179 may convert an electrical signal into a mechanical stimulus (e.g., a vibration or a movement) or electrical stimulus which may be recognized by a user via his tactile sensation or kinesthetic sensation. According to an embodiment, the haptic module 179 may include, for example, a motor, a piezoelectric element, or an electric stimulator.

The camera module 180 may capture a still image or moving images. According to an embodiment, the camera module 180 may include one or more lenses, image sensors, image signal processors, or flashes.

The power management module 188 may manage power supplied to the electronic device 101. According to an embodiment, the power management module 188 may be implemented as at least part of, for example, a power management integrated circuit (PMIC).

The battery 189 may supply power to at least one component of the electronic device 101. According to an embodiment, the battery 189 may include, for example, a primary cell which is not rechargeable, a secondary cell which is rechargeable, or a fuel cell.

The communication module 190 may support establishing a direct (e.g., wired) communication channel or a wireless communication channel between the electronic device 101 and the external electronic device (e.g., the electronic device 102, the electronic device 104, or the server 108) and performing communication via the established communication channel. The communication module 190 may include one or more communication processors that are operable independently from the processor 120 (e.g., the application processor (AP)) and supports a direct (e.g., wired) communication or a wireless communication. According to an embodiment, the communication module 190 may include a wireless communication module 192 (e.g., a cellular communication module, a short-range wireless communication module, or a global navigation satellite system (GNSS) communication module) or a wired communication module 194 (e.g., a local area network (LAN) communication module or a power line communication (PLC) module). A corresponding one of these communication modules may communicate with the external electronic device via the first network 198 (e.g., a short-range communication network, such as Bluetooth^{™}, wireless-fidelity (Wi-Fi) direct, or infrared data association (IrDA)) or the second network 199 (e.g., a long-range communication network, such as a legacy cellular network, a 5G network, a next-generation communication network, the Internet, or a computer network (e.g., LAN or wide area network (WAN)). These various types of communication modules may be implemented as a single component (e.g., a single chip), or may be implemented as multi components (e.g., multi chips) separate from each other. The wireless communication module 192 may identify and authenticate the electronic device 101 in a communication network, such as the first network 198 or the second network 199, using subscriber information (e.g., international mobile subscriber identity (IMSI)) stored in the subscriber identification module 196.

The wireless communication module 192 may support a 5G network, after a 4G network, and next-generation communication technology, e.g., new radio (NR) access technology. The NR access technology may support enhanced mobile broadband (eMBB), massive machine type communications (mMTC), or ultra-reliable and low-latency communications (URLLC). The wireless communication module 192 may support a high-frequency band (e.g., the mmWave band) to achieve, e.g., a high data transmission rate. The wireless communication module 192 may support various technologies for securing performance on a high-frequency band, such as, e.g., beamforming, massive multiple-input and multiple-output (massive MIMO), full dimensional MIMO (FD-MIMO), array antenna, analog beam-forming, or large scale antenna. The wireless communication module 192 may support various requirements specified in the electronic device 101, an external electronic device (e.g., the electronic device 104), or a network system (e.g., the second network 199). According to an embodiment, the wireless communication module 192 may support a peak data rate (e.g., 20Gbps or more) for implementing eMBB, loss coverage (e.g., 164dB or less) for implementing mMTC, or U-plane latency (e.g., 0.5ms or less for each of downlink (DL) and uplink (UL), or a round trip of 1ms or less) for implementing URLLC.

The antenna module 197 may transmit or receive a signal or power to or from the outside (e.g., the external electronic device) of the electronic device 101. According to an embodiment, the antenna module 197 may include an antenna including a radiating element composed of a conductive material or a conductive pattern formed in or on a substrate (e.g., a printed circuit board (PCB)). According to an embodiment, the antenna module 197 may include a plurality of antennas (e.g., array antennas). In such a case, at least one antenna appropriate for a communication scheme used in the communication network, such as the first network 198 or the second network 199, may be selected, for example, by the communication module 190 (e.g., the wireless communication module 192) from the plurality of antennas. The signal or the power may then be transmitted or received between the communication module 190 and the external electronic device via the selected at least one antenna. According to an embodiment, another component (e.g., a radio frequency integrated circuit (RFIC)) other than the radiating element may be additionally formed as part of the antenna module 197.

According to various embodiments, the antenna module 197 may form a mmWave antenna module. According to an embodiment, the mmWave antenna module may include a printed circuit board, an RFIC disposed on a first surface (e.g., the bottom surface) of the printed circuit board, or adjacent to the first surface and capable of supporting a designated high-frequency band (e.g., the mmWave band), and a plurality of antennas (e.g., array antennas) disposed on a second surface (e.g., the top or a side surface) of the printed circuit board, or adjacent to the second surface and capable of transmitting or receiving signals of the designated high-frequency band.

At least some of the above-described components may be coupled mutually and communicate signals (e.g., commands or data) therebetween via an inter-peripheral communication scheme (e.g., a bus, general purpose input and output (GPIO), serial peripheral interface (SPI), or mobile industry processor interface (MIPI)).

According to an embodiment, commands or data may be transmitted or received between the electronic device 101 and the external electronic device 104 via the server 108 coupled with the second network 199. Each of the electronic devices 102 or 104 may be a device of a same type as, or a different type, from the electronic device 101. According to an embodiment, all or some of operations to be executed at the electronic device 101 may be executed at one or more of the external electronic devices 102, 104, or 108. For example, if the electronic device 101 should perform a function or a service automatically, or in response to a request from a user or another device, the electronic device 101, instead of, or in addition to, executing the function or the service, may request the one or more external electronic devices to perform at least part of the function or the service. The one or more external electronic devices receiving the request may perform the at least part of the function or the service requested, or an additional function or an additional service related to the request, and transfer an outcome of the performing to the electronic device 101. The electronic device 101 may provide the outcome, with or without further processing of the outcome, as at least part of a reply to the request. To that end, a cloud computing, distributed computing, mobile edge computing (MEC), or client-server computing technology may be used, for example. The electronic device 101 may provide ultra low-latency services using, e.g., distributed computing or mobile edge computing. In another embodiment, the external electronic device 104 may include an internet-of-things (IoT) device. The server 108 may be an intelligent server using machine learning and/or a neural network. According to an embodiment, the external electronic device 104 or the server 108 may be included in the second network 199. The electronic device 101 may be applied to intelligent services (e.g., smart home, smart city, smart car, or healthcare) based on 5G communication technology or IoT-related technology.

As communication technology advances, an electronic device (e.g., the electronic device 101) may include an RFFE module supporting a plurality of RF frequency bands. For example, the electronic device 101 may transmit RF signals in two or more different frequency bands. While the number of supporting frequency bands increases, antenna efficiency may be reduced due to spatial limitation of the electronic device 101. In addition, due to a grip of a user or movement of the electronic device 101, it may be difficult to maintain antenna performance continuously. To overcome limited performance that may be achieved from one antenna, antenna switching diversity (AS-DIV) technology may be used. The antenna switching diversity technology may include selection of a transmission antenna so that the electronic device 101 including two or more antennas may secure maximum performance by recognizing an electric field situation. For example, the electronic device 101 may receive signals through antennas, and select a transmission antenna by analyzing quality and/or strength of the reception signals.

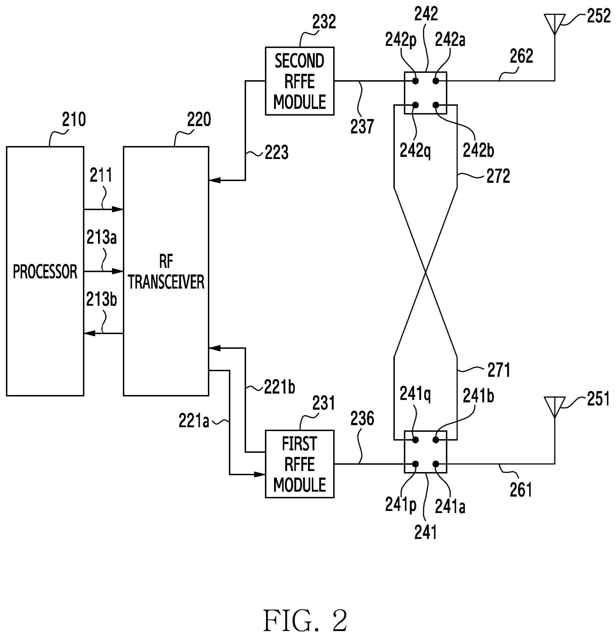

FIG. 2 indicates an example of an electronic device (e.g., the electronic device 101) for antenna switching diversity (AS-DIV).

Referring to FIG. 2, the electronic device 101 may include a processor 210, an RF transceiver 220, a first radio frequency front end (RFFE) module 231, a second RFFE module 232, a first antenna 251, and a second antenna 252. The electronic device 101 may include the processor 210. The processor 210, for example, may include at least one of an application processor (AP) (e.g., the main processor 121 of FIG. 1) or a communication processor (CP) (e.g., the auxiliary processor 123 of FIG. 1). For example, the processor 210 may include the AP and the CP. For example, the processor 210 may include the AP. For example, the processor 210 may include the CP. The processor 210 may control the RF transceiver 220 through a control interface (e.g., a control signal 211). For example, the processor 210 may generate a baseband signal. The processor 210 may control the RF transceiver 220 to process the generated baseband signal. The processor 210 may transmit a signal 213a (e.g., analog data or digital data). For example, the signal 213a may be a communication signal to be transmitted to an external electronic device (e.g., a base station, a satellite, a terminal, an electronic device 102, an electronic device 104, or a server 108). The processor 210 may control the RF transceiver 220 to transmit the signal through an antenna (e.g., the first antenna 251). The processor 210 may receive a signal 213b (e.g., analog data or digital data). For example, the signal 213b may be a signal received from an external electronic device (e.g., the base station, the satellite, the terminal, the electronic device 102, the electronic device 104, or the server 108) through an antenna (e.g., the first antenna 251 or the second antenna 252). The processor 210 may control the RF transceiver 220 to receive the signal 213b.

The electronic device 101 may include the RF transceiver 220. For example, the RF transceiver 220 may be implemented as a single chip (e.g., an RFIC chip) or as a portion of a single package. The RF transceiver 220 may include components for processing a transmission signal. For example, the RF transceiver 220 may provide the first RFFE module 231 with an RF signal (e.g., a transmission signal 221a). The RF transceiver 220 may include a digital to analog converter (DAC) for converting a digital signal into an analog signal. The RF transceiver 220 may include a mixer and an oscillator (e.g., a local oscillator (LO)) for up-conversion. The RF transceiver 220 may convert a baseband signal generated by the processor 210 into an RF signal. The RF transceiver 220 may include components for processing a reception signal. For example, the RF transceiver 220 may receive an RF signal (e.g., a first reception signal 221b or a second reception signal 223) from the second RFFE module 232. The RF transceiver 220 may include an analog to digital converter (ADC) for converting an analog signal into a digital signal. The RF transceiver 220 may include a mixer and an oscillator for down-conversion. The RF transceiver 220 may convert an RF signal received from the antenna (e.g., the first antenna 251 or the second antenna 252) into a baseband signal to be processed by the processor 210. The RF transceiver 220 may include one or more transmission ports. The RF transceiver 220 may include one or more reception ports. Although not illustrated in FIG. 2, the RF transceiver 220 may receive a feedback signal provided from a coupler connected to the antenna (e.g., the first antenna 251 or the second antenna 252). For example, the RF transceiver 220 may include a feedback receive port (FBRX) for a feedback signal. According to an embodiment, the RF transceiver 220 may control at least a portion of the first RFFE module 231 or the second RFFE module 232 through a control interface (e.g., a mobile industry processor interface (MIPI)).

The electronic device 101 may include RFFE modules (e.g., the first RFFE module 231 and the second RFFE module 232). A wireless communication system is developing in a direction for supporting a higher data transmission rate to meet an ever-increasing traffic demand of wireless data. For example, in order to support various frequency combinations, components of a plurality of transmit (TX)/receive (RX) modules, transmission modules, or reception modules connected to the RF transceiver 220 may be disposed. According to an embodiment, in an RFFE, the first RFFE module 231 may indicate a module including a power amplifier (PA) for an RF signal (e.g., the transmission signal 221a). For example, the first RFFE module 231 may be a PAMid including the power amplifier and RF components (e.g., a duplexer, a filter, or a switch) for processing a transmission signal. The first RFFE module 231 may be configured to transmit the transmission signal 221a from the RF transceiver 220 through the first antenna 251 or the second antenna 252. A transmission signal 221 from the RF transceiver 220 may be amplified by the power amplifier. The amplified transmission signal may be radiated into air through the first antenna 251 or the second antenna 252. According to an embodiment, the first RFFE module 231 may include a module (e.g., LPAMid) including not only the power amplifier but also a low noise amplifier (e.g., a LNA) for the RF signal (e.g., the first reception signal 221b). For example, the first RFFE module 231 may include RF components (e.g., the duplexer, the filter, or the switch) for processing a reception signal. The first RFFE module 231 may provide the RF transceiver 220 with the signal (e.g., the first reception signal 221b) received through the first antenna 251 or the second antenna 252. According to an embodiment, in the RFFE, the second RFFE module 232 may indicate a module including the LNA for an RF signal (e.g., the second reception signal 223). For example, the second RFFE module 232 may be a reception module including RF components (e.g., the duplexer, the filter, or the switch) for processing the reception signal. The second RFFE module 232 may be configured to transmit the signal received through the first antenna 251 or the second antenna 252 to the RF transceiver 220.

Antenna switching diversity technology is a technology selecting adaptively an antenna for transmitting a signal among a plurality of antennas (e.g., the first antenna 251 or the second antenna 252). For example, the electronic device 101 may change the antenna for transmitting the signal due to an environmental factor such as an electric field situation or a grip state of a user. The electronic device 101 may include a first switching circuit 241 and a second switching circuit 242 for the antenna switching diversity technology. The first switching circuit 241 may be connected to the first RFFE module 231. The first switching circuit 241 may receive a transmission signal (e.g., the transmission signal 221a) from the first RFFE module 231 or transmit a reception signal (e.g., the first reception signal 221b) to the first RFFE module 231. The second switching circuit 242 may be connected to the second RFFE module 232. The second switching circuit 242 may transmit the reception signal (e.g., the second reception signal 223) to the second RFFE module 232. In an embodiment, the first switching circuit 241 and the second switching circuit 242 of the electronic device 101 may operate in a first connection mode or a second connection mode.

According to an embodiment, in the first connection mode, the first switching circuit 241 may be configured to electrically connect the first RFFE module 231 to the first antenna 251. In the first connection mode, the second switching circuit 242 may be configured to electrically connect the second RFFE module 232 to the second antenna 252. While the first RFFE module 231 is electrically connected to the first antenna 251, the second RFFE module 232 may be electrically connected to the second antenna 252. For example, the electronic device 101 may transmit a transmission signal through the first antenna 251 in the first connection mode. For example, the electronic device 101 may receive a reception signal through the first antenna 251 in the first connection mode. For example, the electronic device 101 may receive a reception signal through the second antenna 252 in the first connection mode.

According to an embodiment, in the second connection mode, the first switching circuit 241 may be configured to electrically connect the first RFFE module 231 to the second antenna 252. The first switching circuit 241 may electrically connect the first RFFE module 231 to the second switching circuit 242 connected to the second antenna 252. For example, the first switching circuit 241 may be configured to electrically connect the first RFFE module 231 and the second antenna 252 through the second switching circuit 242. In the second connection mode, the second switching circuit 242 may be configured to electrically connect the second RFFE module 232 to the first antenna 251. The second switching circuit 242 may electrically connect the second RFFE module 232 to the first switching circuit 241 connected to the first antenna 251. For example, the second switching circuit 242 may be configured to electrically connect the second RFFE module 232 and the first antenna 251 through the first switching circuit 241. While the first RFFE module 231 is electrically connected to the second antenna 252, the second RFFE module 232 may be electrically connected to the first antenna 251. For example, the electronic device 101 may transmit a transmission signal through the second antenna 252 in the second connection mode. For example, the electronic device 101 may receive a reception signal through the second antenna 252 in the second connection mode. For example, the electronic device 101 may receive a reception signal through the first antenna 251 in the first connection mode.

According to an embodiment, the first switching circuit 241 may be configured to electrically connect the first RFFE module 231 to the first antenna 251 in the first connection mode or electrically connect the second antenna 252 through the second switching circuit 242 in the second connection mode, selectively. The first antenna 251 may be electrically connected to the first switching circuit 241 through a first antenna path 261. The second antenna 252 may be electrically connected to the first switching circuit 241 through a second antenna path 262 and the second switching circuit 242. For example, the first switching circuit 241 may include a multiple pole multiple throw (MPMT). As an example, the first switching circuit 241 may include a double pole double throw (DPDT) switch. For example, the first switching circuit 241 may include a first pole 241p, a second pole 241q, a first throw 241a, and a second throw 241b. The first pole 241p may be connected to the first RFFE module 231 through a transmission/reception path 236. The second pole 241q may be connected to the second switching circuit 242 (e.g., a second throw 242b of the second switching circuit 242) through a second wiring 272. The first throw 241a may be electrically connected to the first antenna 251 through the first antenna path 261. The second throw 241b may be connected to the second switching circuit 242 (e.g., a second pole 242q of the second switching circuit 242) through a first wiring 271.

According to an embodiment, the second switching circuit 242 may be configured to electrically connect the second RFFE 232 module to the second antenna 252 in the first connection mode or electrically connect the first antenna 251 through the first switching circuit 241 in the second connection mode, selectively. The first antenna 251 may be connected to the second switching circuit 242 through the first antenna path 261 and the first switching circuit 241. The second antenna 252 may be electrically connected to the second switching circuit 242 through the second antenna path 262. For example, the second switching circuit 242 may include a multiple pole multiple throw (MPMT). As an example, the second switching circuit 242 may include a DPDT switch.

For example, the second switching circuit 242 may include a first pole 242p, the second pole 242q, a first throw 242a, and the second throw 242b. The first pole 242p may be connected to the second RFFE module 232 through a reception path 237. The second pole 242q may be connected to the first switching circuit 241 (e.g., the second throw 241b of the first switching circuit 241) through the first wiring 271. The first throw 242a may be electrically connected to the second antenna 252 through the second antenna path 262. The second throw 242b may be connected to the first switching circuit 241 (e.g., the first pole 241q of the first switching circuit 241) through the second wiring 272.

Due to a characteristic of an RF signal, loss may occur due to a wiring. In order to reduce loss of a feeding line, an RFFE module may be disposed close to an antenna. For example, the first RFFE module 231 may be disposed close to the first antenna 251. For example, the second RFFE module 232 may be disposed close to the second antenna 252. If the first switching circuit 241 and the second switching circuit 242 are implemented as one switch (e.g., a DPDT switch), a position of the switch and the second RFFE module 232 may be restricted due to a position of the first RFFE module 231. Accordingly, if a wiring length from the second RFFE module 232 to the second antenna 252 is increased, the loss of the feeding line may increase. Therefore, the electronic device 101 may individually include the first switching circuit 241 for the first RFFE module 231 and the second switching circuit 242 for the second RFFE module 232. As the first switching circuit 241 connecting the first RFFE module 231 and antennas (e.g., the first antenna 251 or the second antenna 252) and the second switching circuit 242 connecting the second RFFE module 232 and antennas (e.g., the first antenna 251 and the second antenna 252) are implemented separately, the second RFFE module 232 may be disposed closer to the second antenna 252. Due to low path loss, in the first connection mode, transmission/reception performance according to the first antenna 251 and reception performance according to the second antenna 252 may be improved.

In the present disclosure, the first connection mode and the second connection mode may be defined to describe operations of the electronic device 101 (e.g., the processor 210, or the RF transceiver 220) according to antenna switching diversity. For example, the first connection mode may indicate a state in which the first RFFE module 231 of the electronic device 101 is electrically connected to the first antenna 251 through the first switching circuit 241 and the second RFFE module 232 of the electronic device 101 is electrically connected to the second antenna 252 through the second switching circuit 242. In terms of the first RFFE module 231 being disposed closer to the first antenna 251 than the second antenna 252 and the second RFFE module 232 being disposed closer to the second antenna 252 than the first antenna 252, the first connection mode may be referred to as a default mode, a preferred mode, a default state, a preferred state, an initial state, an initial mode, a basic mode, a main path mode, a preferred configuration, a main path configuration, and/or an equivalent technical term. For example, the second connection mode may indicate a state in which the first RFFE module 231 of the electronic device 101 is electrically connected to the second antenna 252 through the first switching circuit 241 and the second switching circuit 242, and the second RFFE module 232 of the electronic device 101 is electrically connected to the first antenna 251 through the second switching circuit 242 and the first switching circuit 241. In terms of a diversity operation, the second connection mode may be referred to as a diversity mode, a switching mode, a non-preferred mode, a non-preferred state, a switching state, a change state, a change mode, a diversity state, a sub-path mode, a non-preferred configuration, a sub-path configuration, and/or an equivalent technical term.

The electronic device 101 (e.g., the processor 210, or the RF transceiver 220) may control the first switching circuit 241 and the second switching circuit 242. In addition, the electronic device 101 (e.g., the processor 210, or the RF transceiver 220) may control the first switching circuit 241 and the second switching circuit 242. For example, the processor 210 may control the first switching circuit 241 to electrically connect the first RFFE module 231 to the first antenna 251 in the first connection mode. The processor 210 may control the second switching circuit 242 to electrically connect the second RFFE module 232 to the second antenna 252 in the first connection mode. Hereinafter, a connection operation of the first switching circuit 241 or a connection operation of the second switching circuit 242 may be understood as control by the processor 210 and/or the RF transceiver 220. The second connection mode indicates a state in which the first RFFE module 231 of the electronic device 101 is electrically connected to the second antenna 252 through the first switching circuit 241 and the second switching circuit 242, and the second RFFE module 232 of the electronic device 101 is electrically connected to the first antenna 251 through the first switching circuit 241 and the second switching circuit 242. For example, the processor 210 may control the first switching circuit 241 and the second switching circuit 242 to electrically connect the first RFFE module 231 to the second antenna 252 in the second connection mode. The processor 210 may control the first switching circuit 241 and the second switching circuit 242 to electrically connect the second RFFE module 232 to the first antenna 251 in the second connection mode. Hereinafter, the connection operation of the first switching circuit 241 or the connection operation of the second switching circuit 242 may be understood as control by the processor 210 and/or the RF transceiver 220.

Hereinafter, in describing embodiments of the present disclosure, the first RFFE module 231 is described as including the transmission/reception module for processing the transmission signal and for processing the reception signal, and the second RFFE module 232 is described as including the reception module for processing the reception signal, but embodiments of the present disclosure are not limited thereto. A description of a module is exemplary only, and a type of the module is not limited. If switching circuits connected to antennas for the antenna switching diversity are respectively connected to a module including a transmission path and another module, it may be understood as an embodiment of the present disclosure. For example, the first RFFE module 231 and/or the second RFFE module 232 may be a module (e.g., FEMid) connected to a transmission path including a power amplifier and a reception path including a low noise amplifier.

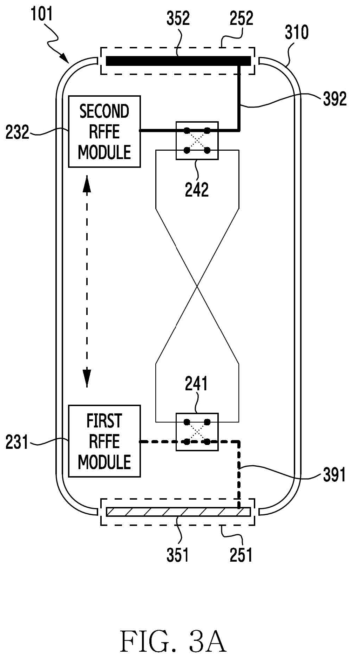

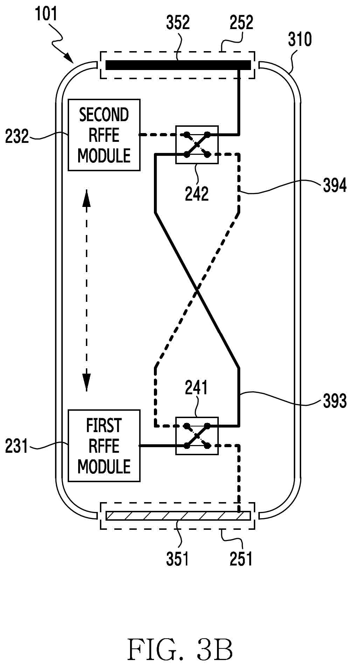

FIGS. 3A and 3B indicate examples of an electronic device (e.g., an electronic device 101) for antenna switching diversity using conductive portions of a metal frame. To describe the antenna switching diversity, a circuitry structure illustrated in FIG. 2 may be referenced. The same reference number may indicate the same description.

Referring to FIGS. 3A and 3B, the electronic device 101 may include a processor 210, an RF transceiver 220, a first RFFE module 231, a second RFFE module 232, a first antenna 251, and a second antenna 252. In an embodiment, the electronic device 101 may include a plurality of switching circuits (e.g., a first switching circuit 241 or a second switching circuit 242) for the antenna switching diversity. The electronic device 101 may include a housing 310. For example, the housing 310 may include a plurality of conductive portions. The plurality of conductive portions may be formed on a side surface of the housing 310. For example, the plurality of conductive portions may be at least a portion of a metal frame of the housing 310. For example, a conductive portion may be formed through segments that are non-conductive portions of the metal frame. Each non-conductive portion may be disposed between the conductive portions. A portion of a conductive portion may be used as an antenna radiator for transmitting or receiving a signal. For example, the electronic device 101 may use a first conductive portion 351 disposed at a lower end of the electronic device 101 as the first antenna 251. For example, the electronic device 101 may use a second conductive portion 352 disposed on the top of the electronic device 101 as the second antenna 252. FIG. 3A indicates a connection state of the plurality of switching circuits in a first connection mode. FIG. 3B indicates a connection state of the plurality of switching circuits in a second connection mode.

Referring to FIG. 3A, in the first connection mode, the first switching circuit 241 may be configured to electrically connect the first RFFE module 231 to the first conductive portion 351. In the first connection mode, a first main path 391 may be formed between the first RFFE module 231 and the first conductive portion 351. The electronic device 101 may transmit or receive a signal through the first main path 391. In the first connection mode, the second switching circuit 242 may be configured to electrically connect the second RFFE module 232 to the second conductive portion 352. In the first connection mode, a second main path 392 may be formed between the second RFFE module 232 and the second conductive portion 352. The electronic device 101 may receive a signal through the second main path 392.

Referring to FIG. 3B, in the second connection mode, the first switching circuit 241 may be configured to electrically connect the first RFFE module 231 to the second conductive portion 352. In the second connection mode, a first sub-path 393 may be formed between the first RFFE module 231 and the second conductive portion 352. The electronic device 101 may transmit or receive a signal through the first sub-path 393. In the second connection mode, the second switching circuit 242 may be configured to electrically connect the second RFFE module 232 to the first conductive portion 351. In the second connection mode, a second sub-path 394 may be formed between the second RFFE module 232 and the first conductive portion 351. The electronic device 101 may receive a signal through the second sub-path 394.

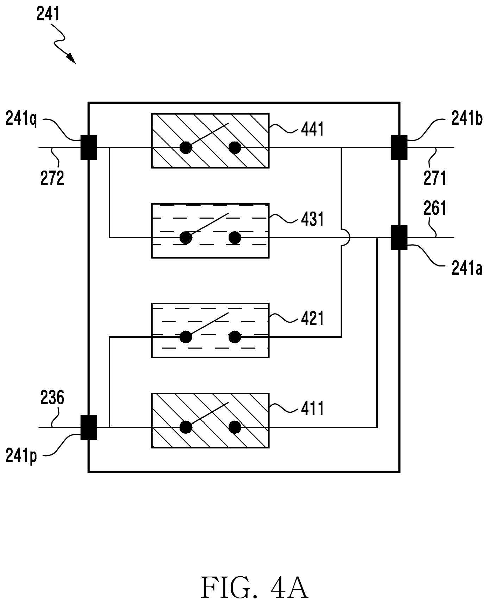

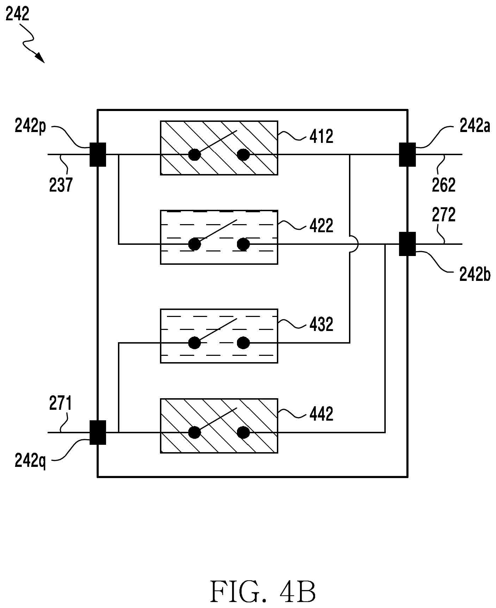

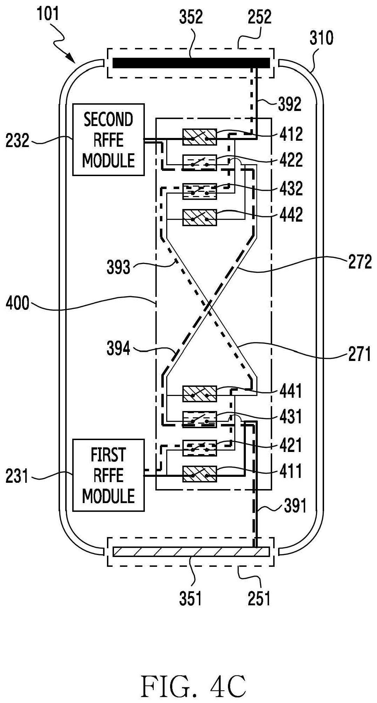

FIGS. 4A, 4B, and 4C indicate examples of a switching circuit (e.g., a first switching circuit 241 or a second switching circuit 242) for antenna switching diversity. In order to describe components in the switching circuit, a description for components of FIGS. 2, 3A, and 3B may be used. The same reference number may indicate the same description.

Referring to FIG. 4A, the first switching circuit 241 may be a DPDT. The first switching circuit 241 may include two poles and two throws. For example, the first switching circuit 241 may include a first pole 241p, a second pole 241q, a first throw 241a, and a second throw 241b. The first switching circuit 241 may include path switches for connecting each pole to each throw.

In a first connection mode, the first pole 241p and the first throw 241a may be electrically connected to form a main path (e.g., a first main path 391) between a first RFFE module 231 and a first antenna 251 (e.g., a first conductive portion 351). The first switching circuit 241 may include a first main path switch 411 for electrically connecting or disconnecting the first pole 241p and the first throw 241a. For example, the first main path switch 411 may be a closed state in the first connection mode and an open state in the second connection mode. While the main path is formed, wirings (e.g., a first wiring 271 or a second wiring 272) between the first switching circuit 241 and the second switching circuit 242 may act as impedance (e.g., stub). For isolation from the main path of the first switching circuit 241, the second pole 241q and the second throw 241b may be electrically connected. The first switching circuit 241 may include a first isolation path switch 441 for electrically connecting or disconnecting the second pole 241q and the second throw 241b. For example, the first isolation path switch 441 may be a closed state in the first connection mode and an open state in the second connection mode.

In the second connection mode, the first pole 241p and the second throw 241b may be electrically connected to form a sub-path (e.g., a first sub-path 393) between the first RFFE module 231 and a second antenna 252 (e.g., a second conductive portion 352). The first RFFE module 231 may be electrically connected to the second switching circuit 242 through an electrical connection between the first pole 241p and the second throw 241b. Since the second switching circuit 242 is electrically connected to the second antenna 252 through an antenna path (e.g., a second antenna path 262), the sub-path between the first RFFE module 231 and the second antenna 252 may be formed. The first switching circuit 241 may include a first sub-path switch 421 for electrically connecting or disconnecting the first pole 241p and the second throw 241b. For example, the first sub-path switch 421 may be a closed state in the second connection mode and an open state in the first connection mode. While the sub-path (e.g., the first sub-path 393) between the first RFFE module 231 and the second antenna 252 is formed, a sub-path (e.g., a second sub-path 394) between the second RFFE module 232 and the first antenna 251 may be formed. For the sub-path of the second RFFE module 232, the second switching circuit 242 connected to the second RFFE module 232 may be connected to the first switching circuit 241 through a wiring (e.g., the second wiring 272). Since the first switching circuit 241 is electrically connected to the first antenna 251 through an antenna path (e.g., a first antenna path 261), the sub-path between the second RFFE module 232 and the first antenna 251 may be formed. For the sub-path of the second RFFE module 232, the first switching circuit 241 may include a first antenna path switch 431 for electrically connecting or disconnecting the second pole 241q and the first throw 241a. For example, the first antenna path switch 431 may be a closed state in the second connection mode and may be an open state in the first connection mode.

Referring to FIG. 4B, the second switching circuit 242 may be a DPDT. The second switching circuit 242 may include two poles and two throws. For example, the second switching circuit 242 may include a first pole 242p, a second pole 242q, a first throw 242a, and a second throw 242b. The second switching circuit 242 may include path switches for connecting each pole to each throw.

In the first connection mode, the first pole 242p and the first throw 242a may be electrically connected to form a main path (e.g., a second main path 392) between the second RFFE module 231 and the second antenna 252 (e.g., the second conductive portion 352). The second switching circuit 242 may include a second main path switch 412 for electrically connecting or disconnecting the first pole 242p and the first throw 242a. For example, the second main path switch 412 may be a closed state in the first connection mode and an open state in the second connection mode. While the main path is formed, the wirings (e.g., the first wiring 271 or the second wiring 272) between the second switching circuit 242 and the first switching circuit 241 may act as impedance. For isolation from the main path of the second switching circuit 242, the second pole 242q and the second throw 242b may be electrically connected. The second switching circuit 242 may include a second isolation path switch 442 for electrically connecting or disconnecting the second pole 242q and the second throw 242b. For example, the second isolation path switch 442 may be a closed state in the first connection mode and an open state in the second connection mode.

In the second connection mode, the first pole 242p and the second throw 242b may be electrically connected to form the sub-path (e.g., the second sub-path 394) between the second RFFE module 232 and the first antenna 251 (e.g., the first conductive portion 351). The second RFFE module 232 may be electrically connected to the first switching circuit 241 through an electrical connection between the first pole 242p and the second throw 242b. Since the first switching circuit 241 is electrically connected to the first antenna 251 through an antenna path (e.g., the first antenna path 261), the sub-path between the second RFFE module 232 and the first antenna 251 may be formed. The second switching circuit 242 may include a second sub-path switch 422 for electrically connecting or disconnecting the first pole 242p and the second throw 242b. For example, the second sub-path switch 422 may be a closed state in the second connection mode and an open state in the first connection mode. While the sub-path (e.g., the second sub-path 394) between the second RFFE module 232 and the first antenna 251 is formed, the sub-path (e.g., the first sub-path 393) between the first RFFE module 231 and the second antenna 252 may be formed. For the sub-path of the first RFFE module 231, the first switching circuit 241 connected to the first RFFE module 231 may be connected to the second switching circuit 242 through a wiring (e.g., the first wiring 271). Since the second switching circuit 242 is electrically connected to the second antenna 252 through an antenna path (e.g., the second antenna path 262), the sub-path between the first RFFE module 231 and the second antenna 252 may be formed. For the sub-path of the first RFFE module 231, the second switching circuit 242 may include a second antenna path switch 432 for electrically connecting or disconnecting the second pole 242q and the first throw 242a. For example, the second antenna path switch 432 may be a closed state in the second connection mode and may be an open state in the first connection mode.

Referring to FIG. 4C, the electronic device 101 may include the processor 210, the RF transceiver 220, the first RFFE module 231, the second RFFE module 232, the first antenna 251, and the second antenna 252. In an embodiment, the electronic device 101 may include a plurality of switching circuits (e.g., the first switching circuit 241 or the second switching circuit 242) for the antenna switching diversity. A description of components for the antenna switching diversity described through FIGS. 2, 3A, and 3B may be applied in substantially the same manner as in FIG. 4C. The first switching circuit 241 may include the first main path switch 411, the first sub-path switch 421, the first antenna path switch 431, and the first isolation path switch 441 exemplified through FIG. 4A. The second switching circuit 242 may include the second main path switch 412, the second sub-path switch 422, the second antenna path switch 432, and the second isolation path switch 442 exemplified through FIG. 4B.

The electronic device 101 may support the antenna switching diversity. In terms of the first RFFE module 231 being disposed closer to the first antenna 251 than the second antenna 252 and the second RFFE module 232 being disposed closer to the second antenna 252 than the first antenna 251, the antenna switching diversity may be referred to as biased antenna switching diversity or asymmetric antenna switching diversity. In order to increase performance of this antenna switching diversity, it is required that loss for transmitting a signal is low in the second connection mode. When referring to a circuit wiring exemplified in FIG. 4C, in the first connection mode, each of the first main path 391 and the second main path 392 may pass through only one switching circuit between an RFFE module and an antenna. However, in the second connection mode, each of the first sub-path 393 and the second sub-path 394 may include two switching circuits (e.g., the first switching circuit 241 and the second switching circuit 242). As an example, in a low band (e.g., a frequency band of less than approximately 1 GHz), loss of DPDT may be approximately 0.4 decibel (dB), and antenna efficiency may be reduced by approximately 10%. In order to alleviate/resolve this problem, in the present disclosure an entire circuit network including path switches of the first switching circuit 241 and path switches of the second switching circuit 242 is regarded as one switch 400, and a circuit structure for distributing isolation of each path and insertion loss of each path may be described. The switch 400 may be understood as one DPDT having inputs connected to the first RFFE module 231 and the second RFFE module 232 and outputs connected to the first antenna 251 and the second antenna 252. In the present disclosure, isolation indicates how much a signal leaks from one port to another port in a state in which a switch connecting ports is off (e.g., the switch is open), and a unit is decibel (dB). Insertion loss indicates an amount of signal loss inserted by a switch in the state in which the switch connecting ports is connected (e.g., the switch is closed), and a unit is dB. As isolation becomes higher, insertion loss becomes higher, so a balance between the isolation and the insertion loss may be required. Hereinafter, characteristics of each path switch are described in respect of insertion loss, but a description of the insertion loss may be applied to isolation in the same technical manner.

According to an embodiment, based on the first RFFE module 231, the first sub-path switch 421 and the second antenna path switch 432 may be designed such that insertion loss from the first main path 391 in the first connection mode is maintained at a level equivalent to insertion loss from the first sub-path 393 in the second connection mode. For example, in a decibel basis, a sum of insertion loss of the first sub-path switch 421 and insertion loss of the second antenna path switch 432 may be within a threshold range in respect of insertion loss of the first main path switch 411. As an example, the threshold range may be approximately ±20% of the insertion loss of the first main path switch 411. As an example, the threshold range may be approximately 1/4 of the insertion loss of the first main path switch 411. Comparison of this insertion loss may be performed under the same environmental condition (e.g., the same frequency range). In case that a maximum value of the insertion loss of the first main path switch 411 is approximately 0.40 dB under a designated condition (e.g., approximately 960 to 2170 MHz), assuming an error range of 20%, the sum (in a decibel unit) of the insertion loss of the first sub-path switch 421 and the insertion loss of the second antenna path switch 432 may be greater than or equal to approximately 0.32 dB and less than approximately 0.48 dB.

When assuming that the first switching circuit 241 and the second switching circuit 242 are designed at the same level, it may be assumed that the first antenna path switch 431 of the first switching circuit 241 has insertion loss equal to insertion loss of the second antenna path switch 432 of the second switching circuit 242. For example, in a decibel basis, a sum of the insertion loss of the first sub-path switch 421 and the insertion loss of the first antenna path switch 431 may be within a threshold range in respect of the insertion loss of the first main path switch 411. According to an embodiment, the first main path switch 411 may be configured to have insertion loss and/or isolation greater than each of the first sub-path switch 421 and the first antenna path switch 431. For example, the insertion loss of the first sub-path switch 421 may be lower than the insertion loss of the first main path switch 411. As an example, the insertion loss of the first sub-path switch 421, in a decibel basis, may be within an error range of approximately 20% in respect of half the insertion loss of the first main path switch 411. As an example, twice the insertion loss of the first sub-path switch 421, in a decibel basis, may be within (e.g., approximately 1/4 of the insertion loss of the first main path switch) the threshold range in respect of the insertion loss of the first main path switch 411. For example, the insertion loss of the first antenna path switch 431 may be lower than the insertion loss of the first main path switch 411. As an example, the insertion loss of the first antenna path switch 431, in a decibel basis, may be within the error range of approximately 20% in respect of half the insertion loss of the first main path switch 411. As an example, twice the insertion loss of the first antenna path switch 431, in a decibel basis, may be within (e.g., approximately 1/4 of the insertion loss of the first main path switch) the threshold range in respect of the insertion loss of the first main path switch 411. Comparison of this insertion loss may be performed under the same environmental condition (e.g., the same frequency range). In case that a maximum value of the insertion loss of the first main path switch 411 is approximately 0.72 dB under a designated condition (e.g., 3800 to 4200 MHz), assuming an error range of approximately 1/4, the insertion loss of each of the first sub-path switch 421 and the first antenna path switch 431 may be greater than or equal to approximately 0.27 dB and less than approximately 0.45 dB based on approximately 0.36 dB under the designated condition. As another example, in case that a maximum value of the insertion loss of the first main path switch 411 is approximately 0.96 dB under a designated condition (e.g., 4400 to 5000 MHz), assuming an error range of approximately 30%, the insertion loss of each of the first sub-path switch 421 and the first antenna path switch 431 may be greater than or equal to approximately 0.336 dB and less than approximately 0.624 dB based on approximately 0.48 dB under the designated condition.

According to an embodiment, based on the second RFFE module 232, the second sub-path switch 422 and the first antenna path switch 431 may be designed such that insertion loss from the second main path 392 in the first connection mode is maintained at a level equal to insertion loss from the second sub-path 394 in the second connection mode. In a decibel basis, a sum of insertion loss of the second sub-path switch 422 and the insertion loss of the first antenna path switch 431 is within a threshold range in respect of insertion loss of the second main path switch 412. As an example, the threshold range may be approximately ±20% of the insertion loss of the second main path switch 412. As an example, the threshold range may be approximately 1/4 of the insertion loss of the second main path switch 412. When assuming that the first switching circuit 241 and the second switching circuit 242 are designed at the same level, it may be assumed that the first antenna path switch 431 of the first switching circuit 241 has insertion loss equal to the second antenna path switch 432 of the second switching circuit 242. For example, in a decibel basis, a sum of the insertion loss of the second sub-path switch 422 and the insertion loss of the second antenna path switch 432 may be within the threshold range in respect of the insertion loss of the second main path switch 412. Comparison of this insertion loss may be performed under the same environmental condition (e.g., the same frequency range). In case that a maximum value of the insertion loss of the second main path switch 412 is approximately 0.50 dB under a designated condition (e.g., 1710 to 2200 MHz), assuming ana error range of approximately 20%, a sum (the decibel unit) of the insertion loss of the second sub-path switch 422 and the insertion loss of the second antenna path switch 431 may be greater than or equal to approximately 0.40 dB and less than approximately 0.60 dB under the designated condition.

According to an embodiment, the second main path switch 412 may be configured to have insertion loss and/or isolation greater than each of the second sub-path switch 422 and the second antenna path switch 432. For example, the insertion loss of the second sub-path switch 422 may be lower than the insertion loss of the second main path switch 412. As an example, the insertion loss of the second sub-path switch 422, in a decibel basis, may be within an error range of approximately 20% in respect of half the insertion loss of the second main path switch 412. As an example, twice the insertion loss of the second sub-path switch 422, in a decibel basis, may be within (e.g., approximately 1/4 of the insertion loss of the second main path switch 412) a threshold range in respect of the insertion loss of the second main path switch 412. For example, the insertion loss of the second antenna path switch 432 may be lower than the insertion loss of the second main path switch 412. As an example, the insertion loss of the second antenna path switch 432, in a decibel basis, may be within the error range of approximately 20% in respect of half the insertion loss of the second main path switch 412. As an example, twice the insertion loss of the second antenna path switch 432, in a decibel basis, may be within (e.g., approximately 1/4 of the insertion loss of the first main path switch) the threshold range in respect of the insertion loss of the second main path switch 412. Comparison of this insertion loss may be performed under the same environmental condition (e.g., the same frequency range). In case that a maximum value of the insertion loss of the second main path switch 412 is approximately 0.35 dB under a designated condition (e.g., 600 to 960 MHz), assuming an error range of approximately 20%, the insertion loss of each of the second sub-path switch 422 and the second antenna path switch 431 may be greater than or equal to approximately 0.14 dB and less than approximately 0.21 dB based on approximately 0.175 dB under the designated condition.

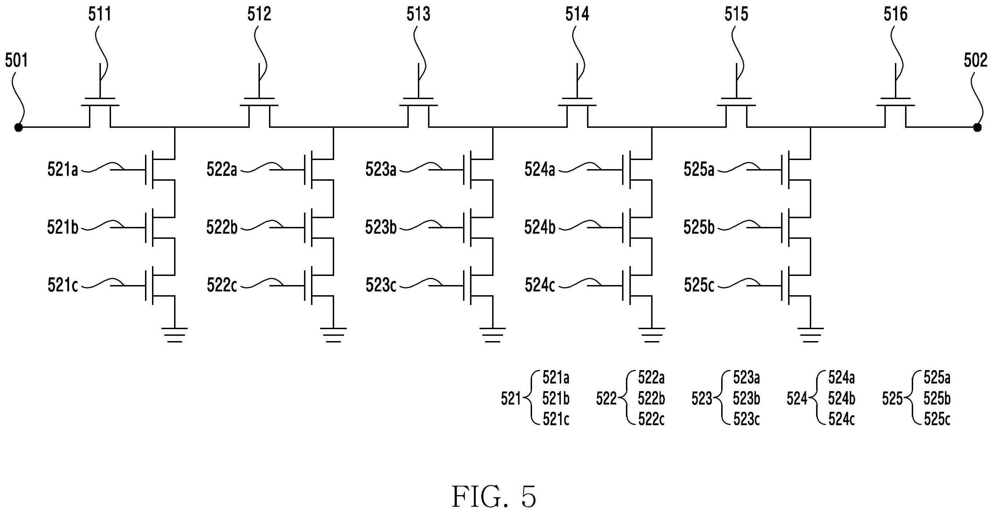

According to an embodiment, path switches may have distributed insertion loss in a sub-path (e.g., the first sub-path 393, or the second sub-path 394) in the second connection mode so as to have a level equivalent to insertion loss/isolation of a path switch of a main path in the first connection mode. Hereinafter, examples of transistors configuring each path switch are described in FIGS. 5 to 7B.

FIG. 5 indicates an example of a path switch (e.g., a first main path switch 411, a first sub-path switch 421, a first antenna path switch 431, a first isolation path switch 441, a second main path switch 412, a second sub-path switch 422, a second antenna path switch 432 or a second isolation path switches 442) of a switching circuit (e.g., a first switching circuit 241 or a second switching circuit 242). In the switching circuit, the path switch may indicate a switch unit forming the switching circuit.

Referring to FIG. 5, a path switch may be configured to electrically connect or disconnect a first port 501 (e.g., a pole) and a second port 502 (e.g., a throw). The path switch may include a plurality of transistors. The path switch may include a series transistor circuitry for connecting the first port 501 and the second port 502. The series transistor circuitry may include transistors (e.g., a field effect transistor (FET)) for connecting an RF path between the first port 501 and the second port 502. As an example, the transistors may be a stacked FET. The transistors may be referred to as series transistors in terms of being connected in series on the RF path. An electronic device 101 may control the path switch to be opened or closed by controlling on/off of gates of the series transistors. For example, the series transistors may include a first series transistor 511, a second series transistor 512, a third series transistor 513, a fourth series transistor 514, a fifth series transistor 515, and/or a sixth series transistor 516. As the series transistors are connected in a cascade manner, a signal having a high voltage greater than or equal to an internal pressure (e.g., a voltage stress) that a transistor may withstand may be transmitted through the RF path between the first port 501 and the second port 502.

The path switch may include shunt transistor circuitries disposed in parallel in the series transistor circuitry connecting the first port 501 and the second port 502. Each shunt transistor circuitry may be used to protect damage due to a surge voltage and to control a current flowing on the RF path between the first port 501 and the second port 502. For example, the shunt transistor circuitries may include a first shunt transistor circuitry 521, a second shunt transistor circuitry 522, a third shunt transistor circuitry 523, a fourth shunt transistor circuitry 524, and/or a fifth shunt transistor circuitry 525. Each shunt transistor circuitry may include transistors (e.g., FETs) disposed in parallel on the RF path and connected to ground. As an example, the transistors may be the stacked FET. The transistors may be referred to as shunt transistors in terms of being a branch from the RF path. For example, the first shunt transistor circuitry 521 may include a first shunt transistor 521a, a second shunt transistor 521b, and/or a third shunt transistor 521c. The first shunt transistor circuitry 521 may be disposed between a node between the first series transistor 511 and the second series transistor 512 and the ground. For example, the second shunt transistor circuitry 522 may include a first shunt transistor 522a, a second shunt transistor 522b, and/or a third shunt transistor 522c. The second shunt transistor circuitry 522 may be disposed between a node between the second series transistor 512 and the third series transistor 513 and the ground. For example, the third shunt transistor circuitry 523 may include a first shunt transistor 523a, a second shunt transistor 523b, and/or a third shunt transistor 523c. The third shunt transistor circuitry 523 may be disposed between a node between the third series transistor 513 and the fourth series transistor 514 and the ground. For example, the fourth shunt transistor circuitry 524 may include a first shunt transistor 524a, a second shunt transistor 524b, and/or a third shunt transistor 524c. The fourth shunt transistor circuitry 524 may be disposed between a node between the fourth series transistor 514 and the fifth series transistor 515 and ground. For example, the fifth shunt transistor circuitry 525 may include a first shunt transistor 525a, a second shunt transistor 525b, and/or a third shunt transistor 525c. The fifth shunt transistor circuitry 525may be disposed between a node between the fifth series transistor 515 and the sixth series transistor 516 and ground. As the shunt transistors are connected in the cascade manner, the signal having the high voltage greater than or equal to the internal pressure (e.g., the voltage stress) that the transistor may withstand may be transmitted through the RF path between the first port 501 and the second port 502.

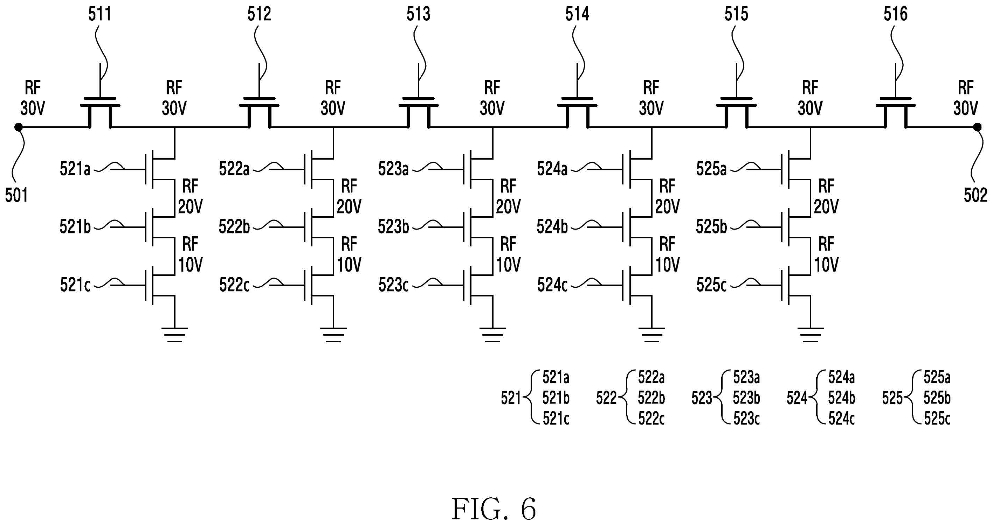

FIG. 6 indicates an example of a turned-on path switch. In order to describe the path switch, a structure of the path switch of FIG. 5 may be referred to.

Referring to FIG. 6, the path switch may be a closed state. In order to electrically connect the first port 501 and the second port 502, series transistors of the path switch may be in an on state. For example, the series transistors may be FETs. As a voltage greater than or equal to a threshold voltage is applied to a gate of each FET, an electrical connection between a source and a drain may be formed. As each of a first series transistor 511, a second series transistor 512, a third series transistor 513, a fourth series transistor 514, a fifth series transistor 515, and/or a sixth series transistor 516 provides the electrical connection between the source and the drain, a current may flow on an RF path between a first port 501 and a second port 502. For example, an RF signal having a voltage of up to approximately 30V may flow through the path switch. The RF signal may be transmitted from the first port 501 to the second port 502 (or from the second port 502 to the first port 501) through the turned-on path switch. Potential on the RF path may be within approximately 30V.

While the current flows on the RF path, all transistors of each shunt transistor circuitry may be in an off state so that the current does not leak to the ground through the shunt transistor circuitries. In case that an RF signal flows on the RF path, the shunt transistor circuitry may be required to withstand a voltage of the RF signal. For example, since the potential is up to approximately 30V in each RF path and the potential of the ground is zero, each shunt transistor circuitry may be designed to withstand an internal pressure of approximately 30V. As a plurality of transistors are used as the shunt transistor circuitry stacked instead of a transistor having a high internal pressure, a voltage stress may be distributed to each transistor. For example, three shunt transistors may be disposed in a cascade manner between a node between two series transistors and the ground. Since a maximum voltage of the RF signal is 30V, an internal pressure applied to each shunt transistor may be within approximately 10V.

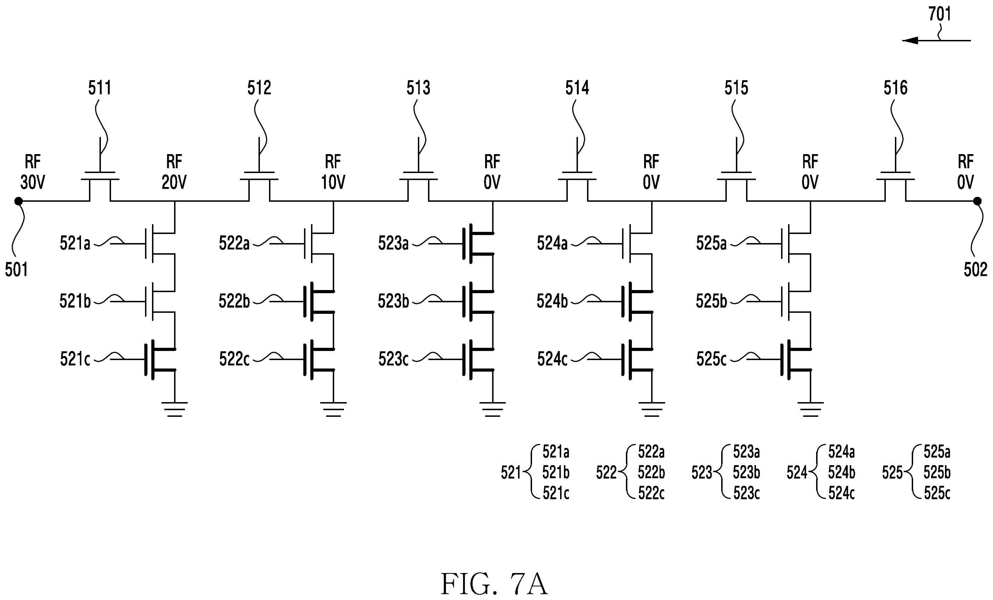

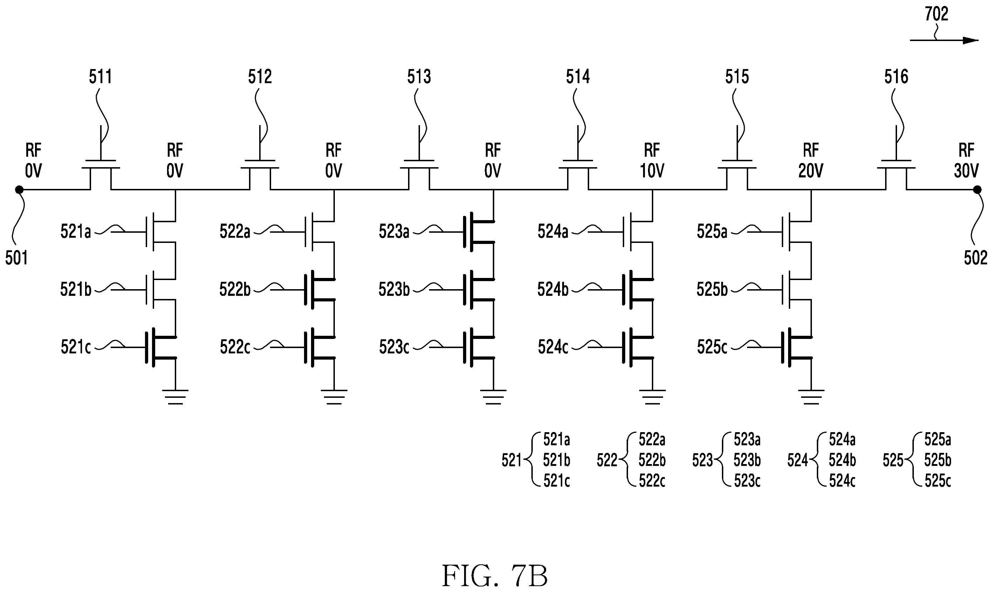

FIGS. 7A and 7B indicate an example of a turned-off path switch. In order to describe the path switch, a structure of the path switch of FIG. 5 may be referred to. In FIG. 7A, an example in which a voltage is applied to a first port 501 but an RF signal is blocked by the path switch is described, and in FIG. 7B, an example in which a voltage is applied to a second port 502 but an RF signal is blocked by the path switch is described.

Referring to FIG. 7A, in order to block an RF signal from the first port 501 to the second port 502, series transistors may be an off state. When assuming that a limit voltage of a transistor is approximately 10V, potential after a first series transistor 511 based on a first direction 701 may be reduced from approximately 30V to approximately 20V. In order to offset a voltage (e.g., approximately 20V) between the ground and the first series transistor 511, among shunt transistor circuitries of a first shunt transistor circuitry 521, a first shunt transistor 521a and a second shunt transistor 521b may be turned off and only a third shunt transistor 521c may be turned on. Potential after the second series transistor 512 may be reduced from approximately 20 V to approximately 10 V based on the first direction 701. In order to offset a voltage (e.g., approximately 20V) between the ground and the second series transistor 512, among shunt transistor circuitries of a second shunt transistor circuitry 522, only a first shunt transistor 522a may be turned off, and a second shunt transistor 522b and a third shunt transistor 522c may be turned on. Potential after a third series transistor 513 based on the first direction 701 may decrease from approximately 10 V to approximately 0 V. In order to offset a voltage (e.g., approximately 30V) between the ground and the third series transistor 513, all of shunt transistor circuitries of a third shunt transistor circuitry 523 may be turned on.

In FIG. 7A, a situation in which an RF signal is applied to the first port 501 is illustrated, an RF signal may also be applied to the second port 502. Since the path switch does not know whether a direction in which the RF signal is applied is left or right, it may have to be designed to undergo a certain level of voltage (e.g., up to approximately 30V) regardless of the direction. The shunt transistor circuitries symmetrically arranged based on a central node 733 may operate in a state (in other words, offsetting the same magnitude of voltage) in which the same number of shunt transistors are activated. For example, in order to block an RF signal with a maximum voltage of approximately 30V through the path switch, the second shunt transistor circuitry 522 may operate in the same way as a fourth shunt transistor circuitry 524. A first shunt transistor 524a of the fourth shunt transistor circuitry 524 may be turned off, and a second shunt transistor 524b and a third shunt transistor 524c may be turned on. For example, in order to block the RF signal with the maximum voltage of approximately 30V through the path switch, a fifth shunt transistor circuitry 525 may operate in the same way as the first shunt transistor circuitry 521. A first shunt transistor 525a and a second shunt transistor 525b of the fifth shunt transistor circuitry 525 may be turned off, and a third shunt transistor 525c may be turned on. Referring to FIG. 7B, in order to block an RF signal from the second port 502 to the first port 501, series transistors may be turned off. When assuming that a limit voltage of a transistor is approximately 10 V, potential after a sixth series transistor 516 based on a second direction 702 may be reduced from approximately 30 V to approximately 20 V. In order to offset a voltage (e.g., approximately 20V) between the ground and the sixth series transistor 516, among shunt transistor circuitries of the fifth shunt transistor circuitry 525, the first shunt transistor 525a and the second shunt transistor 525b may be turned off and only the third shunt transistor 525c may be turned on.

Potential after the fifth series transistor 515 may be reduced from approximately 20 V to approximately 10 V based on the second direction 702. In order to offset a voltage (e.g., approximately 20V) between the ground and the fifth series transistor 515, among shunt transistor circuitries of the fourth shunt transistor circuitry 524, only the first shunt transistor 524a may be turned off, and the second shunt transistor 524b and the third shunt transistor 524c may be turned on. Potential after the third series transistor 513 based on the second direction 702 may be reduced from approximately 10 V to approximately 0 V. In order to offset a voltage (e.g., approximately 30V) between the ground and the third series transistor 513, all of shunt transistor circuitries of the third shunt transistor circuitry 523 may be turned on.

FIG. 7B, a situation in which the RF signal is applied to the second port 502 is illustrated, the RF signal may also be applied to the first port 501. Since the path switch does not know whether a direction in which the RF signal is applied is left or right, it may have to be designed to undergo a certain level of voltage (e.g., up to approximately 30V) regardless of the direction. The shunt transistor circuitries symmetrically arranged based on the central node 733 may operate in a state (in other words, offsetting the same magnitude of voltage) in which the same number of shunt transistor(s) is activated. For example, in order to block the RF signal with the maximum voltage of approximately 30V through the path switch, the second shunt transistor circuitry 522 may operate in the same way as the fourth shunt transistor circuitry 524. The first shunt transistor 522a of the second shunt transistor circuitry 522 may be turned off, and the second shunt transistor 522b and the third shunt transistor 522c may be turned on. For example, in order to block the RF signal with the maximum voltage of approximately 30V through the path switch, the first shunt transistor circuitry 521 may operate in the same way as the fifth shunt transistor circuitry 525. The first shunt transistor 521a and the second shunt transistor 521b of the first shunt transistor circuitry 521 may be turned off, and the third shunt transistor 521c may be turned on.

Isolation, as described in FIGS. 7A and 7B, is an indicator of how much a current leaks from the first port 501 to the second port 502 (or from the second port 9502 to the first port 501) when the path switch is turned off. A path switch that provides high isolation performance requires more transistors to be arranged. Therefore, as the number of units in which transistors are connected in a cascade manner increases, the isolation may increase. On the other hand, as the number of total transistors increases as the number of units increases, resistance and a capacitor connected in parallel also increase. Due to the increasing resistance and capacitor, insertion loss of the path switch may increase. In a circuitry structure for antenna switching diversity, the electronic device 101 according to embodiments of the present disclosure may include switching circuits (e.g., a first switching circuit 241 or a second switching circuit 242) to maintain isolation of a sub-path (e.g., a first sub-path 393, or a second sub-path 394) at a level substantially equal to isolation of a main path (e.g., a first main path 391, or a second main path 392), and to provide insertion loss of the sub-path at a level substantially equal to the insertion loss of the main path. As an example, within a target range of isolation, the switching circuits may have a circuitry structure in which insertion loss are distributed across the first switching circuit 241 and the second switching circuit 242 on the sub-path.

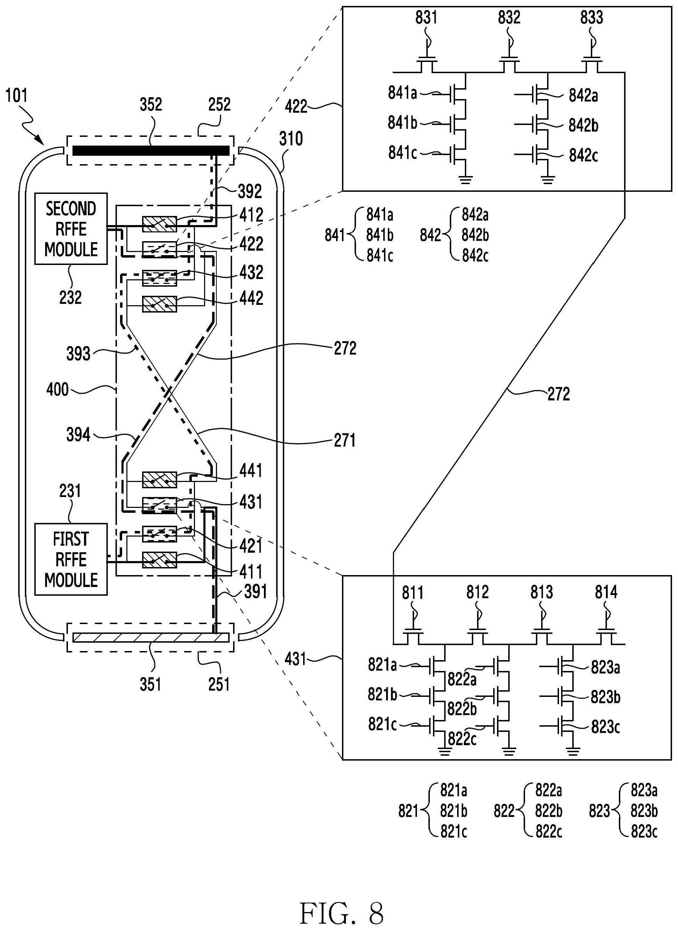

FIG. 8 indicates an example of transistors of two switching circuits (e.g., a first switching circuit 241 and a second switching circuit 242) on a signal path.

Referring to FIG. 8, an electronic device 101 may include the first switching circuit 241. The first switching circuit 241 may include a first main path switch 411, a first sub-path switch 421, a first antenna path switch 431, and a first isolation path switch 441. The electronic device 101 may include the second switching circuit 242. The second switching circuit 242 may include a second main path switch 412, a second sub-path switch 422, a second antenna path switch 432, and a second isolation path switch 442.

For example, in a first connection mode, a first RFFE module 231 may be electrically connected to a first antenna 251 (e.g., a first conductive portion 351) through the first main path switch 411. In the first connection mode, a second RFFE module 232 may be electrically connected to a second antenna 252 (e.g., a second conductive portion 352) through the second main path switch 412. In a second connection mode, the first RFFE module 231 may be electrically connected to the second antenna 252 (e.g., the second conductive portion 352) through a first sub-path 393. In the second connection mode, the first sub-path switch 421 of the first switching circuit 241 may be an on state and the second antenna path switch 432 of the second switching circuit 242 may be the on state. For example, in the second connection mode, the second RFFE module 232 may be electrically connected to the first antenna 251 (e.g., the first conductive portion 351) through a second sub-path 394. In the second connection mode, the second sub-path switch 422 of the second switching circuit 242 may be in the on state and the first antenna path switch 431 of the first switching circuit 241 may be in the on state.

A requirement for isolation from a main path (e.g., a first main path 391 or a second main path 392) may be applied substantially the same in a sub-path (e.g., a first sub-path 393, or a second sub-path 394). For example, in an entire circuitry system for antenna switching diversity, assume that when a single DPDT is used, isolation required in a circuitry structure (e.g., a circuitry structure, when a real DPDT switch is used instead of a switch 400 including two DPDTs) is greater than approximately 35 dB. A switching circuit (e.g., the first switching circuit 241 or the second switching circuit 242) may be designed to reduce insertion loss on a path while meeting the requirement (e.g., greater than approximately 35 dB) for the isolation. In order to lower insertion loss from the sub-path, transistors may be distributed. For example, distribution of the insertion loss may be understood as division of the transistors.

According to an embodiment, transistors may be distributed across two switching circuits (e.g., the first switching circuit 241 or the second switching circuit 242) spatially separated in the electronic device 101. A disposition in which transistors having isolation/insertion loss level (e.g., within approximately ±20%, ±25%, or ±30% error range) equivalent to transistors of the main path switch (e.g., the first main path switch 411, or the second main path switch 412) are distributed across two switching circuits may be understood as an embodiment of the present disclosure. It may be assumed that each path switch is formed of substantially an equal capability of transistors. According to an embodiment, a sum of the number of transistors of the first sub-path switch 421 and the number of transistors of the second antenna path switch 432 may be within a threshold range (e.g., approximately ±20%, ±30%, or ±A/4 (herein, A is the number of transistors of the first main path switch 411)) in respect to the number of transistors of the first main path switch 411. If the first switching circuit 241 and the second switching circuit 242 are DPDT switches implemented in the same manner, the second antenna path switch 432 may have the same transistor circuitry as the first antenna path switch 431. According to an embodiment, a sum of the number of transistors of the first sub-path switch 421 and the number of transistors of the first antenna path switch 431 may be within the threshold range (e.g., approximately ±20%, ±30%, or ±A/4 (herein, A is the number of the transistors of the first main path switch 411)) in respect to the number of the transistors of the first main path switch 411. If the first sub-path switch 421 and the first antenna path switch 431 are formed identically, each of the first sub-path switch 421 and the first antenna path switch 431 may include transistors corresponding to half the number of the transistors of the first main path switch 411. According to an embodiment, the number of the transistors of the first sub-path switch 421 may be within the threshold range (e.g., approximately ±20%, ±30%, or ±A/4 (herein, A is the number of the transistors of the first main path switch 411)) in respect to 1/2 of the number of the transistors of the first main path switch 411 . According to an embodiment, the number of the transistors of the first antenna path switch 431 may be within (e.g., approximately ±20%, ±30%, or ±A/4 (herein, A is the number of the transistors of the first main path switch 411) the threshold range in respect to 1/2 of the number of the transistors of the first main path switch 411.

In an embodiment, each of the second main path switch 412 and the second isolation path switch 442 may have the transistors illustrated in FIGS. 5 to 7B. For example, the transistors illustrated in FIGS. 5 to 7b may be distributed across the second sub-path switch 422 and the first antenna path switch 431 to provide isolation/insertion loss substantially equivalent to the second main path 392 even in the second sub-path 394. The second sub-path switch 422 may include series transistors. For example, the second sub-path switch 422 may include a first series transistor 831, a second series transistor 832, and/or a third series transistor 833. The second sub-path switch 422 may include shunt transistor circuitries for controlling a current flowing through the series transistors. For example, the second sub-path switch 422 may include a first shunt transistor circuitry 841 and/or a second shunt transistor circuitry 842. As an example, in case that a maximum voltage on a path is approximately 30V, shunt transistor circuitries may include three transistors so that only a voltage stress less than or equal to approximately 10V is applied per one transistor. The first shunt transistor circuitry 841 may include a first shunt transistor 841a, a second shunt transistor 841b, and a third shunt transistor 841c. The second shunt transistor circuitry 842 may include a first shunt transistor 842a, a second shunt transistor 842b, and a third shunt transistor 842c.

In the above-described example, each of the first main path switch 411 and the first isolation path switch 441 of the first switching circuit 241 may be designed to have isolation greater than or equal to approximately 35 dB. Therefore, a sum of isolation of the first sub-path switch 421 and isolation of the second antenna path switch 432 may also be required to be greater than or equal to approximately 35 dB. If the first switching circuit 241 and the second switching circuit 242 are designed in the same manner, a sum of the isolation of the first sub-path switch 421 and isolation of the first antenna path switch 431 may be required to be greater than or equal to approximately 35 dB. Within these requirements, insertion loss may be distributed between two switching circuits (e.g., the first switching circuit 241 or the second switching circuit 242). For example, each of the second sub-path switch 422 of the second switching circuit 242 and the first antenna path switch 431 of the first switching circuit 241, in a decibel basis, may be designed to have isolation greater than equal to approximately 17.5 dB, which is half the previously required isolation threshold (e.g., approximately 35 dB). As the requirement of the isolation is lowered, each of the second sub-path switch 422 and the first antenna path switch 431 may be designed to have lower insertion loss. According to an embodiment, each of the first sub-path switch 421 and the first antenna path switch 431 of the first switching circuit 241 may vary within a threshold range (e.g., within approximately ±30% error range, within approximately ±20% error range) in respect to approximately 17.5 dB, in consideration of possibility of an error on a process and deformation for optimizing performance, and the like when designing a DPDT.

In FIG. 8, an example in which three series transistors and two shunt switching circuits are disposed in the second sub-path switch 422 and four series transistors and three shunt switching circuits are disposed in the first antenna path switch 431 has been described, but a distributed structure exemplified in FIG. 8 is only an example, and embodiments of the present disclosure are not limited thereto. As an example without limitation, a disposition in which the second sub-path switch 422 includes five series transistors and four shunt switching circuits, and the first antenna path switch 431 includes two series transistors and one shunt switching circuit may also be an example of the present disclosure.

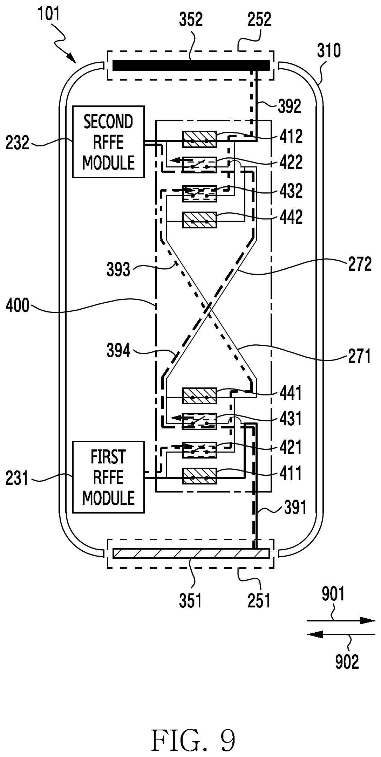

FIG. 9 is a diagram for describing an RF stress direction.

Referring to FIG. 9, an electronic device 101 may operate in a first connection mode. A first RFFE module 231 may be electrically connected to a first antenna 251 through a first main path switch 411 of a first switching circuit 241. A second RFFE module 232 may be electrically connected to a second antenna 252 through a second main path switch 412 of a second switching circuit 242. In the first connection mode, each of the first main path switch 411 of the first switching circuit 241 and a first isolation path switch 441 of the first switching circuit 241 may be in an on state. In the first connection mode, each of a first sub-path switch 421 of the first switching circuit 241 and a first antenna path switch 431 of the first switching circuit 241 may be in an off state. In the first connection mode, each of the second main path switch 412 and a second isolation path switch 442 of the second switching circuit 242 may be in an on state. In the first connection mode, each of a second sub-path switch 422 of the second switching circuit 242 and a second antenna path switch 432 of the second switching circuit 242 may be in an off state.

While a path switch is turned off, since the path switch offsets a voltage of an RF signal provided to a port of the path switch, the path switch may experience an RF stress. At least one shunt transistor may be turned off to offset the voltage of the RF signal while the path switch is turned off. As described in FIGS. 7A and 7B, a direction (hereinafter, an RF stress direction) of an RF stress may be determined according to a port on which an RF signal is provided. Since power of a transmission signal is greater than power of a reception signal, an RF stress direction of a path switch may be affected by a direction of a transmission path. For example, an RF stress direction may be determined from a port electrically connected to the first RFFE module 231 to another port among both ports of the path switch. As an example, an RF stress direction of the first sub-path switch 421 may be a first direction 901. An RF stress direction of the first antenna path switch 431 may be a second direction 902. An RF stress direction of the second sub-path switch 422 may be the second direction 902. An RF stress direction of the second antenna path switch 432 may be the first direction 901.

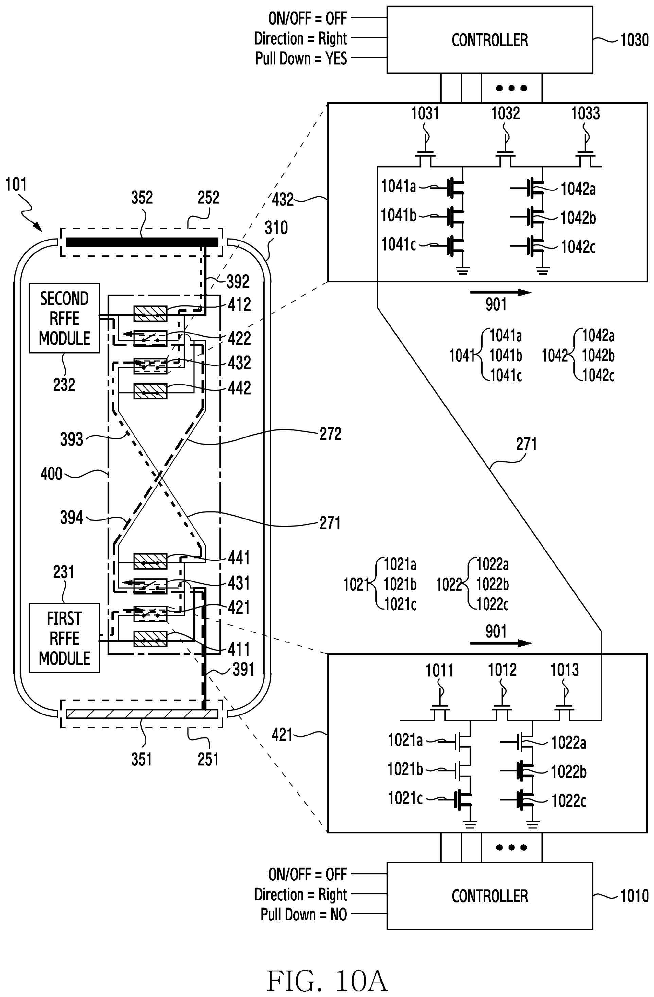

According to an embodiment, since it is possible to know whether a direction in which an RF signal is applied is the first direction 901 or the second direction 902, a path switch may not be symmetrically designed based on a central node (e.g., the central node 733) of a switch. According to an embodiment, the same number of shunt transistor may not be activated in shunt transistor circuitries symmetrically arranged based on the center node of the path switch. Since the RF stress direction is not known, a required constraint is unnecessary, so the path switch may be designed in a more simplified manner. Since unnecessary transistors are not included in the path switch, less insertion loss may be provided. Hereinafter, an example of a design of the path switch in consideration of the RF stress direction will be described through FIGS. 10A to 10B.

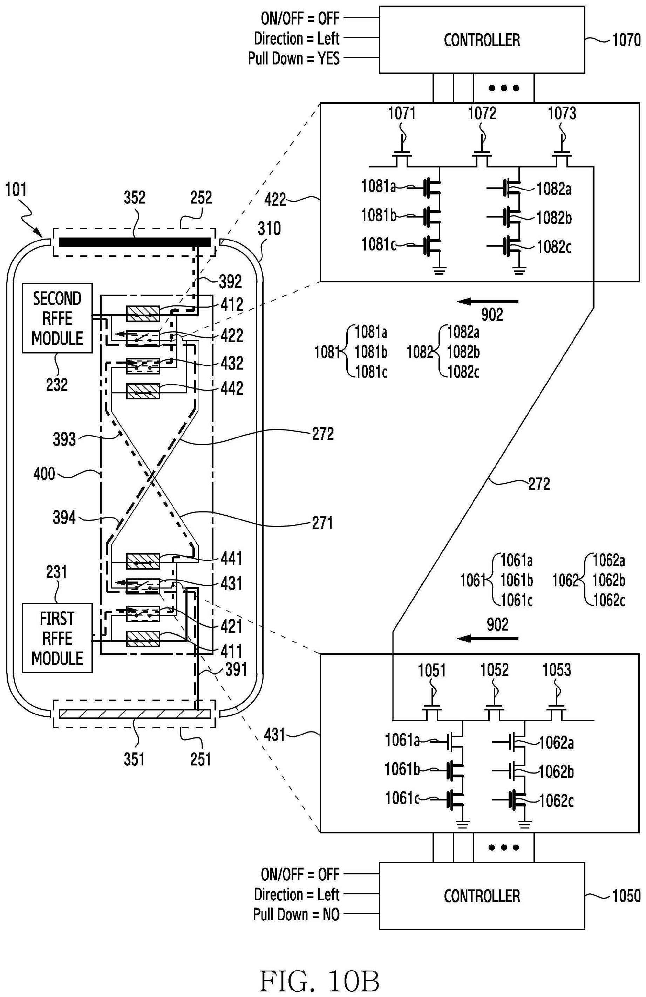

FIGS. 10A and 10B indicate an example of transistors of two switching circuits (e.g., a first switching circuit 241 and a second switching circuit 242) on a signal path according to an RF stress direction. In FIG. 10A, transistors of path switches with an RF stress direction in a first direction 901 are illustrated, and in FIG. 10B, transistors of path switches with an RF stress direction in a second direction 902 are illustrated. The same reference number may be used for the same description.

Referring to FIG. 10A, an electronic device 101 may operate in a first connection mode of antenna switching diversity. As the first connection mode operates, path switches of a first sub-path 393 formed in a second connection mode may be turned off. An RF stress direction of each of the turned-off path switches may be the RF stress direction of the first direction 901. Shunt transistors of each of a first sub-path switch 421 and a second antenna path switch 432 may operate according to the RF stress direction. For example, the electronic device 101 may include a first controller 1010 for controlling the first sub-path switch 421 and a second controller 1030 for controlling the second antenna path switch 432.

In an embodiment, the electronic device 101 may include the first controller 1010. The first controller 1010 may be a transistor control circuitry for the first sub-path switch 421. The first controller 1010 may control whether each transistor of the first sub-path switch 421 is on or off in accordance with a first input (e.g., set as "OFF" in the first connection mode) indicating whether the first sub-path switch 421 is on or off, a second input (e.g., indicating the first direction 901 toward "right") indicating a designated direction, and a third input for indicating whether pull-down is performed or not (e.g., not performed ("NO")). The designated direction may indicate an RF stress direction. The pull-down may indicate that all shunt transistors are turned on. For example, in case that the first input indicates on of the first sub-path switch 421, series transistors of the first sub-path switch 421 may all be turned on, and shunt transistors of the first sub-path switch 421 may all be turned off. In case that the first input indicates off of the first sub-path switch 421, the series transistors of the first sub-path switch 421 may all be turned off. In case that the first input indicates off of the first sub-path switch 421, shunt transistors to be activated (in other words, to be turned on) among the shunt transistors of the first sub-path switch 421 may be determined in accordance with the second input and the third input.

In an embodiment, the electronic device 101 may include the second controller 1030. The second controller 1030 may be a transistor control circuitry for the second antenna path switch 432. The second controller 1030 may control whether each transistor of the second antenna path switch 432 is on or off in accordance with a first input (e.g., set as "OFF" in the first connection mode) indicating whether the second antenna path switch 432 is on or off, a second input (e.g., indicating the first direction 901 toward "right") indicating a designated direction, and a third input for indicating whether pull-down is performed or not (e.g., performed ("YES")). In case that the first input indicates on of the second antenna path switch 432, series transistors of the second antenna path switch 432 may all be turned on, and shunt transistors of the second antenna path switch 432 may all be turned off. In case that the first input indicates off of the second antenna path switch 432, the series transistors of the second antenna path switch 432 may all be turned off. In case that the first input indicates off of the second antenna path switch 432, the shunt transistors to be activated (in other words, to be turned on) among the shunt transistors of the second antenna path switch 432 may be determined in accordance with the second input and the third input.

The first sub-path switch 421 may include the series transistors and the shunt transistor circuitries. For example, the series transistors may include a first series transistor 1011, a second series transistor 1012, and/or a third series transistor 1013. The shunt transistor circuitries may include a first shunt transistor circuitry 1021 and a second shunt transistor circuitry 1022. The first shunt transistor circuitry 1021 may include a first shunt transistor 1021a, a second shunt transistor 1021b, and a third shunt transistor 1021c. The second shunt transistor circuitry 1022 may include a first shunt transistor 1022a, a second shunt transistor 1022b, and a third shunt transistor 1022c.

The second antenna path switch 432 may include the series transistors and the shunt transistor circuitries. For example, the series transistors may include a first series transistor 1031, a second series transistor 1032, and/or a third series transistor 1033. The shunt transistor circuitries may include a first shunt transistor circuitry 1041 and a second shunt transistor circuitry 1042. The first shunt transistor circuitry 1041 may include a first shunt transistor 1041a, a second shunt transistor 1041b, and a third shunt transistor 1041c. The second shunt transistor circuitry 1042 may include a first shunt transistor 1042a, a second shunt transistor 1042b, and a third shunt transistor 1042c.

Assume that an RF signal having a voltage of up to approximately 30V is transmitted through a transmission path. When assuming that a maximum voltage applied to a port of a path switch is approximately 30V and an internal pressure that a transistor may withstand is the maximum of 10V, each shunt transistor circuitry may include three shunt transistors. In addition, since the shunt transistor circuitry is connected between two series transistors and an RF voltage is sequentially offset in each series transistor, at least three shunt transistor circuitries may be required in a path (e.g., the first sub-path 393) between an RFFE module and an antenna. Through this principle, the number of shunt transistors activated in each transistor circuitry may increase in an ascending order according to the designated direction (e.g., the first direction 901). According to an embodiment, the number of shunt transistor(s) activated in each shunt transistor circuitry may gradually increase up to the maximum number (e.g., three) of shunt transistors connected between an electrical path corresponding to the first sub-path 393 and the ground. For example, in the first connection mode, only the third shunt transistor 1021c among the shunt transistors of the first shunt transistor circuitry 1021 may be turned on and the first shunt transistor 1021a and the second shunt transistor 1021b may be turned off. Among the shunt transistors of the second shunt transistor circuitry 1022, the second shunt transistor 1022b and the third shunt transistor 1022c may be turned on and the first shunt transistor 1022a may be turned off. Thereafter, all the shunt transistors of the first shunt transistor circuitry 1041 and the second shunt transistor circuitry 1042 of the second antenna path switch 432 may be turned on.

The first controller 1010 of the electronic device 101 may control on/off of the corresponding transistor by transmitting a control signal to each transistor of the first sub-path switch 421. The second controller 1030 of the electronic device 101 may control on/off of the corresponding transistor by transmitting a control signal to each transistor of the second antenna path switch 432. As an example, an operation of the first controller 1010 may operate according to logic as the following table. '0' of each transistor indicates off and '1' indicates on.

[Table 1]

| | Input | | Control Signal | | | | | | | | |
|---|---|---|---|---|---|---|---|---|---|---|---|
| First Input (OFF: 0, 1: ON) | Third Input (Pull down) (0: Yes, 1: No) | Second Input (direction) (0: Left, 1: Right) | First Series transistor 1011 | Second series transistor 1012 | Third series transistor 1013 | First Shunt Transist or 1021a | First Shunt Trans istor 1021 b | First Shunt Transi stor 1021c | First Shunt Transist or 1022a | First Shunt Transist or 1022b | First Shunt Transist or 1022c |
| 0 | 0 | 0 | 0 | 0 | 0 | 0 | 1 | 1 | 0 | 0 | 1 |
| | | 1 | 0 | 0 | 0 | 0 | 0 | 1 | 0 | 1 | 1 |
| | 1 | 0 | 0 | 0 | 0 | 1 | 1 | 1 | 1 | 1 | 1 |
| | | 1 | 0 | 0 | 0 | 1 | 1 | 1 | 1 | 1 | 1 |
| 1 | 0 | 0 | 1 | 1 | 1 | 0 | 0 | 0 | 0 | 0 | 0 |
| | | 1 | 1 | 1 | 1 | 0 | 0 | 0 | 0 | 0 | 0 |
| | 1 | 0 | 1 | 1 | 1 | 0 | 0 | 0 | 0 | 0 | 0 |
| | | 1 | 1 | 1 | 1 | 0 | 0 | 0 | 0 | 0 | 0 |

Table 1 is described in respect to the first controller 1010, but embodiments of the present disclosure are not limited thereto. As illustrated in FIG. 10A, since the first sub-path switch 421 and the second antenna path switch 432 include the same number of series transistors and shunt transistors, operations according to Table 1 may be applied equally to the second controller 1020.

Referring to FIG. 10B, the electronic device 101 may operate in the first connection mode of the antenna switching diversity. As the first connection mode operates, the path switches of a first sub-path 394 formed in the second connection mode may be turned off. An RF stress direction of each of the turned-off path switches may be the RF stress direction of the second direction 902. The shunt transistors of each of a second sub-path switch 422 and a first antenna path switch 431 may operate according to the RF stress direction. For example, the electronic device 101 may include a first controller 1050 for controlling the first antenna path switch 431 and a second controller 1070 for controlling the second sub path switch 422.

The electronic device 101 may include the first controller 1050. The first controller 1050 may be a transistor control circuitry for the first antenna path switch 431. The first controller 1050 may control whether each transistor of the first antenna path switch 431 is on or off in accordance with a first input (e.g., set as "OFF" in the first connection mode) indicating whether the first antenna path switch 431 is on or off, a second input (e.g., indicating the second direction 902 toward "left") indicating a designated direction, and a third input for indicating whether pull-down is performed or not (e.g., not performed ("NO")). For example, in case that the first input indicates on of the first antenna path switch 431, series transistors of the first antenna path switch 431 may all be turned on, and shunt transistors of the first antenna path switch 431 may all be turned off. In case that the first input indicates off of the first antenna path switch 431, the series transistors of the first antenna path switch 431 may all be turned off. In case that the first input indicates off of the first antenna path switch 431, shunt transistors to be activated (in other words, to be turned on) among the shunt transistors of the first antenna path switch 431 may be determined in accordance with the second input and the third input.

The electronic device 101 may include the second controller 1070. The second controller 1070 may be a transistor control circuitry for the second sub-path switch 422. The second controller 1070 may control whether each transistor of the second antenna path switch 432 is on or off in accordance with a first input (e.g., set as "OFF" in the first connection mode) indicating whether the second sub-path switch 422 is on or off, a second input (e.g., indicating the second direction 902 toward "left") indicating a designated direction, and a third input for indicating whether pull-down is performed or not (e.g., performed ("YES")). For example, in case that the first input indicates on of the second antenna path switch 432, series transistors of the second sub-path switch 422 may all be turned on, and shunt transistors of the second sub-path switch 422 may all be turned off. In case that the first input indicates off of the second sub-path switch 422, the series transistors of the second sub-path switch 422 may all be turned off. In case that the first input indicates off of the second sub-path switch 422, shunt transistors to be activated (in other words, to be turned on) among the shunt transistors of the second sub-path switch 422 may be determined in accordance with the second input and the third input.

The first antenna path switch 431 may include the series transistors and the shunt transistor circuitries. The series transistors may include a first series transistor 1051, a second series transistor 1052, and a third series transistor 1053. The shunt transistor circuitries may include a first shunt transistor circuitry 1061 and a second shunt transistor circuitry 1062. The first shunt transistor circuitry 1061 may include a first shunt transistor 1061a, a second shunt transistor 1061b, and a third shunt transistor 1061c. The second shunt transistor circuitry 1062 may include a first shunt transistor 1062a, a second shunt transistor 1062b, and a third shunt transistor 1062c. As an example, the first controller 1050 may control the first antenna path switch 431 according to Table 1.

The second sub-path switch 422 may include the series transistors and the shunt transistor circuitries. The series transistors may include a first series transistor 1071, a second series transistor 1072, and a third series transistor 1073. The shunt transistor circuitries may include a first shunt transistor circuitry 1081 and a second shunt transistor circuitry 1082. The first shunt transistor circuitry 1081 may include a first shunt transistor 1081a, a second shunt transistor 1081b, and a third shunt transistor 1081c. The second shunt transistor circuitry 1082 may include a first shunt transistor 1082a, a second shunt transistor 1082b, and a third shunt transistor 1082c. As an example, the second controller 1070 may control the second sub-path switch 422 according to Table 1.

Assume that an RF signal having a voltage of up to approximately 30V is transmitted through a transmission path. When assuming that a maximum voltage applied to a port of a path switch is approximately 30V and an internal pressure that a transistor may withstand is the maximum of 10V, a shunt transistor circuitry may include three shunt transistors. In addition, since the shunt transistor circuitry is connected between two series transistors and an RF voltage is sequentially offset in each series transistor, at least three shunt transistor circuitries may be required in a path (e.g., a second sub-path 394) between an RFFE module and an antenna. Through this principle, the number of shunt transistors activated in each transistor circuitry may increase in an ascending order according to the designated direction (e.g., the second direction 902). According to an embodiment, the number of shunt transistor(s) activated in each shunt transistor circuitry may gradually increase up to the maximum number (e.g., three) of shunt transistors connected between an electrical path corresponding to the second sub-path 394 and the ground. For example, in the first connection mode, only the third shunt transistor 1061c among the shunt transistors of the first shunt transistor circuitry 1061 may be turned on and the first shunt transistor 1061a and the second shunt transistor 1061b may be turned off. Among the shunt transistors of the second shunt transistor circuitry 1062, the second shunt transistor 1062b and the third shunt transistor 1062c may be turned on and the first shunt transistor 1062a may be turned off. Thereafter, the shunt transistors of the first shunt transistor circuitry 1081 and the second shunt transistor circuitry 1082 of the second sub-path switch 422 may all be turned on.

Referring to a circuitry structure illustrated in FIG. 10B and a circuitry structure of FIG. 8, it may be confirmed that the number of transistors included in the second sub-path switch 422 and the number of transistors included in the first antenna path switch 431 is reduced. Since an RF stress direction is not known in FIG. 8, even if it is designed to withstand the RF stress of up to approximately 30V, additional shunt transistor circuitries are required. However, since the transistor circuitry in FIG. 10B is determined by an activation method of shunt transistors according to an RF stress direction, the number of transistors included in the path switch may be reduced. As an example, the number of shunt transistor is 15 in FIG. 8 , but shunt transistor circuitries are 12 in FIG. 10B.

An electronic device (e.g., an electronic device 101) according to embodiments of the present disclosure may include a switching circuit (e.g., the first switching circuit 241 or the second switching circuit 242) connected to each RFFE module to overcome limitation of a physical distance between an RFFE module and an antenna in implementing antenna switching diversity. In this time, in the second connection mode, isolation may be required to reduce path loss due to two switching circuits (e.g., the first switching circuit 241 and the second switching circuit 242). The electronic device 101 may include a structure in which transistors for meeting requirement with respect to isolation are distributed in two switching circuits. In addition, a disposition of shunt transistors in the path switch may be designed (e.g., optimized) based on an RF stress direction of each path switch in the switching circuit. As insertion loss decreases due to the smaller number of transistors in the second connection mode, communication performance in the second connection mode may be improved.

The effects that may be obtained from the present disclosure are not limited to those described above, and any other effects not mentioned herein will be clearly understood by those having ordinary knowledge in the art to which the present disclosure belongs, from the following description.

In embodiments, an electronic device 101 is provided. The electronic device 101 may comprise a plurality of antennas including a first antenna 251 and a second antenna 252, a radio frequency (RF) transceiver 220, a first radio frequency front end (RFFE) module 231 connected to the RF transceiver 220 and configured to transmit or receive signals, a second RFFE module 232 connected to the RF transceiver 220 and configured to receive signals, a first switching circuit 241 connected to the first RFFE module 231, and a second switching circuit 242 connected to the second RFFE module 232. The first switching circuit 241 may be configured to electrically connect the first RFFE module 231 to the first antenna 251 in a first connection mode or the second antenna 252 through the second switching circuit 242 in a second connection mode selectively. The second switching circuit 242 may be configured to electrically connect the second RFFE module 232 to the second antenna 252 in the first connection mode or the first antenna 251 through the first switching circuit 241 in the second connection mode selectively. In the first switching circuit 241, insertion loss of a first sub-path switch 421 configured to connect the first RFFE module 231 and the second switching circuit 242 electrically in the second connection mode may be lower than insertion loss of a first main path switch 411 configured to connect the first RFFE module 231 and the first antenna 251 electrically in the first connection mode. In the second switching circuit 242, insertion loss of a second sub-path switch 422 configured to connect the second RFFE module 232 and the first switching circuit 241 electrically in the second connection mode may be lower than insertion loss of a second main path switch 412 configured to connect the second RFFE module 232 and the second antenna 252 in the first connection mode.

For example, in the first connection mode, the first RFFE module 231 may be electrically connected to the first antenna 251 through the first main path switch 411 of the first switching circuit 241. In the second connection mode, the first RFFE module 231 may be electrically connected to the second antenna 252 through the first sub-path switch 421 of the first switching circuit 241 and a second antenna path switch 432 of the second switching circuit 242. In a decibel basis, a sum of the insertion loss of the first sub-path switch 421 and insertion loss of the second antenna path switch 432 may be within a threshold range in respect of the insertion loss of the first main path switch 411.

For example, the threshold range may indicate an error range corresponding to 1/4 of the insertion loss of the first main path switch 411 in respect of the insertion loss of the first main path switch 411.

For example, in the first connection mode, the second RFFE module 232 may be electrically connected to the second antenna 252 through the second main path switch 412 of the second switching circuit 242. In the second connection mode, the second RFFE module 232 may be electrically connected to the first antenna 251 through the second sub-path switch 422 of the second switching circuit 242 and a first antenna path switch 431 of the first switching circuit 241. In a decibel basis, a sum of the insertion loss of the second sub-path switch 422 and insertion loss of the first antenna path switch 431 may be within a threshold range in respect of the insertion loss of the second main path switch 412, corresponding to 1/4 of the insertion loss of the second main path switch 412.

For example, a number of transistors of the first sub-path switch 421 may be smaller than a number of transistors of the first main path switch 411. A number of transistors of the second sub-path switch 422 may be smaller than a number of transistors of the second main path switch 412.

For example, the transistors of the first main path switch 411 may include series transistors disposed in series and shunt transistor circuitries disposed in parallel, in respect to a path between the first RFFE module 231 and the first antenna 251. The transistors of the second main path switch 412 may include series transistors disposed in series and shunt transistor circuitries disposed in parallel, in respect to a path between the second RFFE module 232 and the second antenna 252. The transistors of the first sub-path switch 421 may include series transistors disposed in series and shunt transistor circuitries disposed in parallel, in respect to a path between the first RFFE module 231 and the second switching circuit 242. The transistors of the second sub-path switch 422 may include series transistors disposed in series and shunt transistor circuitries disposed in parallel, in respect to a path between the second RFFE module 232 and the first switching circuit 241.

For example, a sum of a number of transistors of the first sub-path switch 421 and a number of transistors of the second antenna path switch 432 may be within a threshold range in respect to a number of transistors of the first main path switch 411. A sum of a number of transistors of the second sub-path switch 422 and a number of transistors of the first antenna path switch 431 may be within a threshold range in respect to a number of transistors of the second main path switch 412.

For example, the first switching circuit 241 may include the first main path switch 411 for connecting the first RFFE module 231 and the first antenna 251, the first sub-path switch 421 for connecting the first RFFE module 231 and the second switching circuit 242, a first antenna path switch 431 for connecting the second switching circuit 242 and the first antenna 251, and a first isolation path switch 441 for connecting with the second switching circuit 242. The second switching circuit 242 may include the second main path switch 412 for connecting the second RFFE module 232 and the second antenna 252, the second sub-path switch 422 for connecting the second RFFE module 232 and the first switching circuit 241, a second antenna path switch 432 for connecting the first switching circuit 241 and the second antenna 252, and a second isolation path switch 442 for connecting with the first switching circuit 241. Each of the first main path switch 411, the first sub-path switch 421, the first antenna path switch 431, the first isolation path switch 441, the second main path switch 412, the second sub-path switch 422, the second antenna path switch 432, and the second isolation path switch 442 may include series transistors for a path connection and shunt transistors connected to ground. The shunt transistors may be turned off while the series transistors are turned on. At least one of the shunt transistors may be turned on while the series transistors are turned off.

For example, the shunt transistors may be divided into a plurality of groups. Each group of the plurality of groups may be connected to a node between two consecutive transistors of different combinations of the series transistors.

For example, series transistors of the first sub-path switch 421 and series transistors of the second antenna path switch 432 may provide an electrical path between the first RFFE module 231 and the second antenna 252. Shunt transistors of the first sub-path switch 421 and shunt transistors of the second antenna path switch 432 may be disposed in parallel to the electrical path. While the series transistors of the first sub-path switch 421 and the series transistor of the second antenna path switch 432 are turned off in the second connection mode, shunt transistors of a subset of the shunt transistors of the first sub-path switch 421 and the shunt transistors of the second antenna path switch 432 may be turned on. Distribution of the shunt transistors of the subset may indicate that, closer one gets to a center of the electrical path from one end of the electrical path, more shunt transistors are turned on.

For example, series transistors of the first sub-path switch 421 and series transistors of the second antenna path switch 432 may provide an electrical path between the first RFFE module 231 and the second antenna 252. Shunt transistors of the first sub-path switch 421 and shunt transistors of the second antenna path switch 432 may be disposed in parallel to the electrical path. While the series transistors of the first sub-path switch 421 and the series transistor of the second antenna path switch 432 may be turned off in the second connection mode, shunt transistors of a subset of the shunt transistors of the first sub-path switch 421 and the shunt transistors of the second antenna path switch 432 may be turned on. Distribution of the shunt transistors of the subset may indicate that the shunt transistors of the subset are arranged in an ascending order within a maximum number of shunt transistors between the electrical path and ground, based on a designated direction.

For example, the electronic device of claim 101 may comprise a first control circuitry for controlling shunt transistors of the first sub-path switch 421, and a second control circuitry for controlling shunt transistors of the second antenna path switch 432. The first control circuitry may be configured to control on or off of each of the shunt transistors of the first sub-path switch 421 in accordance with a first input indicating whether the first sub-path switch 421 is on or off, a second input indicating the designated direction, and a third input indicating whether pull-down for turning on all shunt-transistors of the first sub-path switch 421 is performed or not. The second control circuitry may be configured to control on or off of each of the shunt transistors of the second antenna path switch 432 in accordance with a first input indicating whether the second antenna path switch 432 is on or off, a second input indicating the designated direction, and a third input indicating whether pull-down for turning on all shunt-transistors of the second antenna path switch 432 is performed or not.

For example, the insertion loss of the first main path switch 411, in a decibel basis, may be within an error range of 20% in respect to a sum of the insertion loss of the first sub-path switch 421 and the insertion loss of the first antenna path switch 431. The insertion loss of the second main path switch 412, in a decibel basis, may be within an error range of 20% in respect to a sum of the insertion loss of the second sub-path switch 422 and the insertion loss of the second antenna path switch 432.

For example, the insertion loss of the first main path switch 411, in a decibel basis, may be within an error range of 20% in respect to a value of twice the insertion loss of the first sub-path switch 421. The insertion loss of the second main path switch 412, in a decibel basis, may be within an error range of 20% in respect to a value of twice the insertion loss of the second sub-path switch 422.

For example, the first switching circuit 241 may be dual-pole dual-throw (DPDT) and the second switching circuit 242 may be DPDT. A first output of the first switching circuit 241 may be electrically connected to the first antenna 251. A first output of the second switching circuit 242 may be electrically connected to the second antenna 252. A first input of the first switching circuit 241 may be electrically connected to the first RFFF module 231 and a second input of the first switching circuit 241 may be electrically connected to a second output of the second switching circuit 242. A first input of the second switching circuit 242 may be electrically connected to the second RFFF module 232 and a second input of the second switching circuit 242 may be electrically connected to a second output of the first switching circuit 241.

In embodiments, a radio frequency (RF) switch is provided. The RF switch may comprise a first port, a second port, a third port, a fourth port, a first path switch for connecting the first port and the third port electrically, a second path switch for connecting the first port and the fourth port electrically, a third path switch for connecting the second port and the third port electrically, and a fourth path switch for connecting the second port and the fourth port electrically. Insertion loss of the second path switch may be lower than insertion loss of the first path switch. A value of twice the insertion loss of the second path switch may be, in a decibel basis, within a threshold range in respect of the insertion loss of the first path switch.

For example, each of the first path switch, the second path switch, the third path switch, and the fourth path switch may include series transistors for a path connection and shunt transistors connected to ground. The shunt transistors may be turned off while the series transistors are turned on. At least one of the shunt transistors may be turned on while the series transistors are turned off.

For example, a number of series transistors of the second path switch may be smaller than a number of series transistors of the first path switch, and a number of shunt transistors of the second path switch may be smaller than a number of shunt transistors of the first path switch.

For example, the threshold range may indicate an error range corresponding to 1/4 of the insertion loss of the first path switch in respect of the insertion loss of the first path switch.

For example, the insertion loss of the first path switch, in a decibel basis, may be within an error range of 20% in respect to a sum of the insertion loss of the second path switch and insertion loss of the third path switch.

The electronic device according to various embodiments may be one of various types of electronic devices. The electronic devices may include, for example, a portable communication device (e.g., a smartphone), a computer device, a portable multimedia device, a portable medical device, a camera, a wearable device, or a home appliance. According to an embodiment of the disclosure, the electronic devices are not limited to those described above.

It should be appreciated that various embodiments of the present disclosure and the terms used therein are not intended to limit the technological features set forth herein to particular embodiments and include various changes, equivalents, or replacements for a corresponding embodiment. With regard to the description of the drawings, similar reference numerals may be used to refer to similar or related elements. It is to be understood that a singular form of a noun corresponding to an item may include one or more of the things unless the relevant context clearly indicates otherwise. As used herein, each of such phrases as "A or B," "at least one of A and B," "at least one of A or B," "A, B, or C," "at least one of A, B, and C," and "at least one of A, B, or C," may include any one of or all possible combinations of the items enumerated together in a corresponding one of the phrases. As used herein, such terms as "1st" and "2nd," or "first" and "second" may be used to simply distinguish a corresponding component from another, and does not limit the components in other aspect (e.g., importance or order). It is to be understood that if an element (e.g., a first element) is referred to, with or without the term "operatively" or "communicatively", as "coupled with," or "connected with" another element (e.g., a second element), it means that the element may be coupled with the other element directly (e.g., wiredly), wirelessly, or via a third element.

As used in connection with various embodiments of the disclosure, the term "module" may include a unit implemented in hardware, software, or firmware, and may interchangeably be used with other terms, for example, "logic," "logic block," "part," or "circuitry". A module may be a single integral component, or a minimum unit or part thereof, adapted to perform one or more functions. For example, according to an embodiment, the module may be implemented in a form of an application-specific integrated circuit (ASIC).

Various embodiments as set forth herein may be implemented as software (e.g., the program 140) including one or more instructions that are stored in a storage medium (e.g., internal memory 136 or external memory 138) that is readable by a machine (e.g., the electronic device 101). For example, a processor (e.g., the processor 120) of the machine (e.g., the electronic device 101) may invoke at least one of the one or more instructions stored in the storage medium, and execute it, with or without using one or more other components under the control of the processor. This allows the machine to be operated to perform at least one function according to the at least one instruction invoked. The one or more instructions may include a code generated by a complier or a code executable by an interpreter. The machine-readable storage medium may be provided in the form of a non-transitory storage medium. Wherein, the term "non-transitory" simply means that the storage medium is a tangible device, and does not include a signal (e.g., an electromagnetic wave), but this term does not differentiate between a case in which data is semi-permanently stored in the storage medium and a case in which the data is temporarily stored in the storage medium.

According to an embodiment, a method according to various embodiments of the disclosure may be included and provided in a computer program product. The computer program product may be traded as a product between a seller and a buyer. The computer program product may be distributed in the form of a machine-readable storage medium (e.g., compact disc read only memory (CD-ROM)), or be distributed (e.g., downloaded or uploaded) online via an application store (e.g., PlayStore^{™}), or between two user devices (e.g., smart phones) directly. If distributed online, at least part of the computer program product may be temporarily generated or at least temporarily stored in the machine-readable storage medium, such as memory of the manufacturer's server, a server of the application store, or a relay server.

According to various embodiments, each component (e.g., a module or a program) of the above-described components may include a single entity or multiple entities, and some of the multiple entities may be separately disposed in different components. According to various embodiments, one or more of the above-described components may be omitted, or one or more other components may be added. Alternatively or additionally, a plurality of components (e.g., modules or programs) may be integrated into a single component. In such a case, according to various embodiments, the integrated component may still perform one or more functions of each of the plurality of components in the same or similar manner as they are performed by a corresponding one of the plurality of components before the integration. According to various embodiments, operations performed by the module, the program, or another component may be carried out sequentially, in parallel, repeatedly, or heuristically, or one or more of the operations may be executed in a different order or omitted, or one or more other operations may be added.

## Claims

1. An electronic device comprising:
a plurality of antennas including a first antenna and a second antenna;
a radio frequency (RF) transceiver;
a first radio frequency front end (RFFE) module connected to the RF transceiver and configured to transmit or receive signals;
a second RFFE module connected to the RF transceiver and configured to receive signals; and
a first switching circuit connected to the first RFFE module; and
a second switching circuit connected to the second RFFE module,
wherein the first switching circuit is configured to electrically connect the first RFFE module to the first antenna in a first connection mode or the second antenna through the second switching circuit in a second connection mode selectively,
wherein the second switching circuit is configured to electrically connect the second RFFE module to the second antenna in the first connection mode or the first antenna through the first switching circuit in the second connection mode selectively,
wherein, in the first switching circuit, insertion loss of a first sub-path switch configured to connect the first RFFE module and the second switching circuit electrically in the second connection mode is lower than insertion loss of a first main path switch configured to connect the first RFFE module and the first antenna electrically in the first connection mode, and
wherein, in the second switching circuit, insertion loss of a second sub-path switch configured to connect the second RFFE module and the first switching circuit electrically in the second connection mode is lower than insertion loss of a second main path switch configured to connect the second RFFE module and the second antenna in the first connection mode.

2. The electronic device of claim 1,
wherein, in the first connection mode, the first RFFE module is electrically connected to the first antenna through the first main path switch of the first switching circuit,
wherein, in the second connection mode, the first RFFE module is electrically connected to the second antenna through the first sub-path switch of the first switching circuit and a second antenna path switch of the second switching circuit, and
wherein, in a decibel basis, a sum of the insertion loss of the first sub-path switch and insertion loss of the second antenna path switch is within a threshold range in respect of the insertion loss of the first main path switch.

3. The electronic device of claim 2, wherein the threshold range indicates an error range corresponding to 1/4 of the insertion loss of the first main path switch in respect of the insertion loss of the first main path switch.

4. The electronic device of claim 3,
wherein, in the first connection mode, the second RFFE module is electrically connected to the second antenna through the second main path switch of the second switching circuit,
wherein, in the second connection mode, the second RFFE module is electrically connected to the first antenna through the second sub-path switch of the second switching circuit and a first antenna path switch of the first switching circuit, and
wherein, in a decibel basis, a sum of the insertion loss of the second sub-path switch and insertion loss of the first antenna path switch is within a threshold range in respect of the insertion loss of the second main path switch, corresponding to 1/4 of the insertion loss of the second main path switch.

5. The electronic device of claim 2,
wherein a number of transistors of the first sub-path switch is smaller than a number of transistors of the first main path switch, and
wherein a number of transistors of the second sub-path switch is smaller than a number of transistors of the second main path switch.

6. The electronic device of claim 5,
wherein the transistors of the first main path switch include series transistors disposed in series and shunt transistor circuits disposed in parallel, in respect to a path between the first RFFE module and the first antenna,
wherein the transistors of the second main path switch include series transistors disposed in series and shunt transistor circuits disposed in parallel, in respect to a path between the second RFFE module and the second antenna,
wherein the transistors of the first sub-path switch include series transistors disposed in series and shunt transistor circuits disposed in parallel, in respect to a path between the first RFFE module and the second switching circuit, and
wherein the transistors of the second sub-path switch include series transistors disposed in series and shunt transistor circuits disposed in parallel, in respect to a path between the second RFFE module and the first switching circuit.

7. The electronic device of claim 5,
wherein a sum of a number of transistors of the first sub-path switch and a number of transistors of the second antenna path switch is within a threshold range in respect to a number of transistors of the first main path switch, and
wherein a sum of a number of transistors of the second sub-path switch and a number of transistors of the first antenna path switch is within a threshold range in respect to a number of transistors of the second main path switch.

8. The electronic device of claim 1,
wherein the first switching circuit includes the first main path switch for connecting the first RFFE module and the first antenna, the first sub-path switch for connecting the first RFFE module and the second switching circuit, a first antenna path switch for connecting the second switching circuit and the first antenna, and a first isolation path switch for connecting with the second switching circuit,
wherein the second switching circuit includes the second main path switch for connecting the second RFFE module and the second antenna, the second sub-path switch for connecting the second RFFE module and the first switching circuit, a second antenna path switch for connecting the first switching circuit and the second antenna, and a second isolation path switch for connecting with the first switching circuit,
each of the first main path switch, the first sub-path switch, the first antenna path switch, the first isolation path switch, the second main path switch, the second sub-path switch, the second antenna path switch, and the second isolation path switch includes series transistors for a path connection and shunt transistors connected to ground,
wherein the shunt transistors are turned off while the series transistors are turned on, and
wherein at least one of the shunt transistors is turned on while the series transistors are turned off.

9. The electronic device of claim 8,
wherein the shunt transistors are divided into a plurality of groups, and
wherein each group of the plurality of groups is connected to a node between two consecutive transistors of different combinations of the series transistors.

10. The electronic device of claim 8,
wherein series transistors of the first sub-path switch and series transistors of the second antenna path switch provides an electrical path between the first RFFE module and the second antenna,
wherein shunt transistors of the first sub-path switch and shunt transistors of the second antenna path switch are disposed in parallel to the electrical path,
wherein, while the series transistors of the first sub-path switch and the series transistor of the second antenna path switch are turned off in the second connection mode, shunt transistors of a subset of the shunt transistors of the first sub-path switch and the shunt transistors of the second antenna path switch are turned on, and
wherein distribution of the shunt transistors of the subset indicates that, closer one gets to a center of the electrical path from one end of the electrical path, more shunt transistors are turned on.

11. The electronic device of claim 8,
wherein series transistors of the first sub-path switch and series transistors of the second antenna path switch provides an electrical path between the first RFFE module and the second antenna,
wherein shunt transistors of the first sub-path switch and shunt transistors of the second antenna path switch are disposed in parallel to the electrical path,
wherein, while the series transistors of the first sub-path switch and the series transistor of the second antenna path switch are turned off in the second connection mode, shunt transistors of a subset of the shunt transistors of the first sub-path switch and the shunt transistors of the second antenna path switch are turned on, and
wherein distribution of the shunt transistors of the subset indicates that the shunt transistors of the subset are arranged in ascending order within a maximum number of shunt transistors between the electrical path and ground, based on a designated direction.

12. The electronic device of claim 11, further comprising:
a first control circuitry for controlling shunt transistors of the first sub-path switch; and
a second control circuitry for controlling shunt transistors of the second antenna path switch,
wherein the first control circuitry is configured to control on or off of each of the shunt transistors of the first sub-path switch in accordance with a first input indicating whether the first sub-path switch is on or off, a second input indicating the designated direction, and a third input indicating whether pull-down for turning on all shunt transistors of the first sub-path switch is performed or not,
wherein the second control circuitry is configured to control on or off of each of the shunt transistors of the second antenna path switch in accordance with a first input indicating whether the second antenna path switch is on or off, a second input indicating the designated direction, and a third input indicating whether pull-down for turning on all shunt-transistors of the second antenna path switch is performed or not,

13. The electronic device of claim 8,
wherein the insertion loss of the first main path switch, in a decibel basis, is within an error range of 20% in respect to a sum of the insertion loss of the first sub-path switch and the insertion loss of the first antenna path switch, and
wherein the insertion loss of the second main path switch, in a decibel basis, is within an error range of 20% in respect to a sum of the insertion loss of the second sub-path switch and the insertion loss of the second antenna path switch.

14. The electronic device of claim 1,
wherein the insertion loss of the first main path switch, in a decibel basis, is within an error range of 20% in respect to a value of twice the insertion loss of the first sub-path switch, and
wherein the insertion loss of the second main path switch, in a decibel basis, is within an error range of 20% in respect to a value of twice the insertion loss of the second sub-path switch.

15. The electronic device of claim 1,
wherein the first switching circuit is dual-pole dual-throw (DPDT) and the second switching circuit is DPDT,
wherein a first output of the first switching circuit is electrically connected to the first antenna,
wherein a first output of the second switching circuit is electrically connected to the second antenna,
wherein a first input of the first switching circuit is electrically connected to the first RFFF module and a second input of the first switching circuit is electrically connected to a second output of the second switching circuit, and
wherein a first input of the second switching circuit is electrically connected to the second RFFF module and a second input of the second switching circuit is electrically connected to a second output of the first switching circuit.
